# EUROPEAN PATENT SPECIFICATION

(11) **EP 4 560 924 B1**
(45) Date of publication and mention of the grant of the patent: **02.09.2026**
(21) Application number: 23854100.7
(22) Date of filing: 28.06.2023
(51) Int. Cl.: H03M 7/20, H03M 5/02, H03M 13/29, H03M 5/16

(54) **CODING METHOD AND APPARATUS, DECODING METHOD AND APPARATUS**
CODIERUNGSVERFAHREN UND -VORRICHTUNG, DECODIERUNGSVERFAHREN UND -VORRICHTUNG
PROCÉDÉ ET APPAREIL DE CODAGE, PROCÉDÉ ET APPAREIL DE DÉCODAGE

(30) Priority: 19.08.2022 CN 202210999759
(43) Date of publication of application: 28.05.2025
(73) Proprietor: Huawei Technologies Co., Ltd., Shenzhen, Guangdong 518129 (CN)
(72) Inventor: YIN, Haifeng, Shenzhen, Guangdong 518129 (CN); CAO, Wei, Shenzhen, Guangdong 518129 (CN)
(74) Representative: Körber, Martin Hans
(86) International application number: PCT/CN2023/103033
(87) International publication number: WO 2024/037195

(56) References cited:
- US-A1- 2015 131 765
- US-A1- 2020 242 062
- US-A1- 2021 234 618
- US-B2- 10 897 382
- PARK HYUNSU ET AL: "30-Gb/s 1.11-pJ/bit Single-Ended PAM-3 Transceiver for High-Speed Memory Links", IEEE JOURNAL OF SOLID-STATE CIRCUITS, IEEE, USA, vol. 56, no. 2, 15 July 2020 (2020-07-15), pages 581 - 590, XP011834675, ISSN: 0018-9200, [retrieved on 20210127], DOI: 10.1109/JSSC.2020.3006864
- PARK HYUNSU ET AL: "A 3-bit/2UI 27Gb/s PAM-3 Single-Ended Transceiver Using One-Tap DFE for Next-Generation Memory Interface", 21 February 2019 (2019-02-21), pages 1 - 3, XP093314668, Retrieved from the Internet <URL:https://ieeexplore.ieee.org/stamp/stamp.jsp?tp=&arnumber=8662462>

## Description

This application claims priority to Chinese Patent Application No. 202210999759.X, filed with the China National Intellectual Property Administration on August 19, 2022 and entitled "ENCODING/DECODING METHOD AND APPARATUS, AND DATA TRANSMISSION METHOD".

### TECHNICAL FIELD

This application relates to the field of communication technologies, and in particular, to an encoding/decoding method and apparatus, and a data transmission method.

### BACKGROUND

In a chiplet (chiplet) interconnection system, data transmission usually occurs between a plurality of chiplets. A channel used for data transmission may be referred to as an interconnection channel, so that one interconnection system may include a plurality of interconnection channels. For a fixed quantity of interconnection channels, an increase in a rate of a single interconnection channel can increase an interconnection bandwidth. However, when a specific rate is reached, a further increase in the rate reduces energy efficiency.

Currently, a multi-level coding scheme is usually used, to increase a signal transmission bandwidth while ensuring that a Baud rate remains unchanged. Pulse amplitude modulation (pulse amplitude modulation), and in particular, PAM3 coding is used as an example, and 3-bit (bit) data may be transmitted in two unit intervals (unit interval, UI) through an interconnection channel, so that an interconnection bandwidth can be increased to 1.5 times that of non-return-to-zero (non-return-to-zero, NRZ) encoding. Document PARK HYUNSU ET AL: "30-Gb/s 1.11-pJ/bit Single-Ended PAM-3 Transceiver for High-Speed Memory Links", IEEE JOURNAL OF SOLID-STATE CIRCUITS, IEEE, USA, vol. 56, no. 2, 15 July 2020 (2020-07-15), pages 581-590, ISSN: 0018-9200, DOI: 10.1109/JSSC.2020.3006864, discloses one of such systems.

However, when encoding/decoding is performed based on current PAM3 encoding/decoding logic, a bit error rate and system error correction costs is high.

### SUMMARY

This application provides an encoding/decoding method and apparatus, and a data transmission method, to resolve a high bit error rate and high system error correction costs in an existing technology due to PAM3 used for encoding and decoding.

To achieve the foregoing objective, this application uses the following technical solutions.

According to a first aspect, an encoding method is provided. The method includes: obtaining to-be-encoded 3-bit data; encoding the 3-bit data, to obtain a 4-bit encoded parity signal, where the 3-bit data includes first bit data A, second bit data B, and third bit data C, and the 4-bit encoded parity signal includes a first encoded odd-bit signal S1, a second encoded odd-bit signal S2, a first encoded even-bit signal S3, and a second encoded even-bit signal S4 that satisfy *S*1=*A•*(*B+C*), *S*2=*A̅•*(*B+C̅*), *S*3=(*A̅+B̅*)•*C*, and *S*4=(*A+B̅*)•*C̅*, where • indicates logical AND, + indicates logical OR, *A̅* indicates an inverted phase of A, *B̅* indicates an inverted phase of B, and *C̅* indicates an inverted phase of C; and generating a three-level pulse amplitude modulation PAM3 signal in two unit intervals based on the 4-bit encoded parity signal, and sending the PAM3 signal.

In the foregoing technical solution, when the to-be-encoded 3-bit data is obtained, and the to-be-encoded 3-bit data is encoded based on encoding logic that the 3-bit data and the 4-bit encoded parity signal satisfy, to obtain the 4-bit encoded parity signal. When the PAM3 signal in the two unit intervals that is generated based on the 4-bit encoded parity signal is sent to a receive end, it can be ensured that the receive end decodes the PAM3 signal based on specific decoding logic, to obtain a bit error in a maximum of 2-bit data in the 3-bit data. In this case, in comparison with a bit error in a maximum of 3-bit data in a related technology, a bit error rate is low, and system error correction costs are further reduced.

In a possible implementation of the first aspect, the encoding the 3-bit data, to obtain a 4-bit encoded parity signal includes: if the 3-bit data is 111, encoding 111, to obtain a 4-bit encoded parity signal 1000; if the 3-bit data is 110, encoding 110, to obtain a 4-bit encoded parity signal 1001; if the 3-bit data is 001, encoding 001, to obtain a 4-bit encoded parity signal 0010; if the 3-bit data is 101, encoding 101, to obtain a 4-bit encoded parity signal 1010; if the 3-bit data is 100, encoding 100, to obtain a 4-bit encoded parity signal 0001; if the 3-bit data is 011, encoding 011, to obtain a 4-bit encoded parity signal 0110; if the 3-bit data is 010, encoding 010, to obtain a 4-bit encoded parity signal 0100; and if the 3-bit data is 000, encoding 000, to obtain a 4-bit encoded parity signal 0101. In the foregoing possible implementation, when the 3-bit data is encoded to obtain the 4-bit encoded parity signal, encoding is performed based on the encoding logic, to obtain the 4-bit encoded parity signal. When the PAM3 signal in the two unit intervals that is generated based on the 4-bit encoded parity signal is sent to the receive end, it can be ensured that the receive end decodes the PAM3 signal based on specific decoding logic, to obtain the 3-bit data with a low bit error rate.

In a possible implementation of the first aspect, the encoded odd-bit signals at the first 2 bits of the 4-bit encoded parity signal are used to generate a PAM3 signal in a 1^{st} unit interval, and the encoded even-bit signals at the last 2 bits are used to generate a PAM3 signal in a 2^{nd} unit interval. In the foregoing possible implementation, when the PAM3 signal in the two unit intervals is generated based on the 4-bit encoded parity signal, the PAM3 signal in a 1^{st} unit interval may be generated based on the first 2 bits of the encoded parity signal, and the PAM3 signal in a 2^{nd} unit interval is generated based on the last 2 bits of the encoded parity signal.

In a possible implementation of the first aspect, the obtaining to-be-encoded 3-bit data includes: receiving a serial bitstream, and dividing the serial bitstream into a plurality of pieces of 3-bit data at a granularity of 3 bits, where the to-be-encoded 3-bit data is any one of the plurality of pieces of 3-bit data. In the foregoing possible implementation, the serial bitstream is divided into the plurality of pieces of 3-bit data at a granularity of 3 bits, and the plurality of pieces of 3-bit data may be separately encoded based on the encoding logic, to reduce a bit error rate during encoding of the serial bitstream.

According to a second aspect, a decoding method is provided. The method includes: obtaining a three-level pulse amplitude modulation PAM3 signal in two unit intervals; determining a 4-bit decoding parity signal based on the PAM3 signal in the two unit intervals; and decoding the 4-bit decoding parity signal, to obtain 3-bit data, where if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000.

In the foregoing technical solution, when the PAM3 signal in the two unit intervals is obtained, the 4-bit decoding parity signal is determined based on the PAM3 signal in the two unit intervals, and the 4-bit decoding parity signal is decoded based on preset decoding logic, to obtain the 3-bit data. In the foregoing process, when a bit error occurs in a PAM3 signal in one UI, in comparison with 3-bit data obtained by decoding a 4-bit decoding parity signal without a bit error, a bit error occurs in a maximum of 2-bit data in 3-bit data obtained by decoding a 4-bit decoding parity signal with a bit error. In this case, in comparison with a bit error in a maximum of 3-bit data in the related technology, a bit error rate is low, and system error correction costs are further reduced.

In a possible implementation of the second aspect, the 4-bit decoding parity signal includes a first decoding odd-bit signal C1, a second decoding odd-bit signal C2, a first decoding even-bit signal C3, and a second decoding even-bit signal C4, and the 3-bit data includes first bit data A, second bit data B, and third bit data C that satisfy *A*=*C*1*+*(*C̅*3*•C*2), *B*=(*̅C̅*̅3̅•*C*4)*+*(*̅C̅*̅3̅•*C*1)*+*(*̅C̅*̅2̅•*C*4), and *C*=*C*3*+C*4*•C*2, where • indicates logical AND, + indicates logical OR, C3 indicates an inverted phase of C3, and C2 indicates an inverted phase of C2. In the foregoing possible implementation, when the 4-bit decoding parity signal is decoded to obtain the 3-bit data, a bit error rate of the 3-bit data obtained by decoding based on the decoding logic is low.

In a possible implementation of the second aspect, the decoding odd-bit signals at the first 2 bits of the 4-bit decoding parity signal are determined based on a PAM3 signal in a 1^{st} unit interval, and the decoding even-bit signals at the last 2 bits are determined based on a PAM3 signal in a 2^{nd} unit interval. In the foregoing possible implementation, when the 4-bit decoding parity signal is determined based on the PAM3 signal in the two unit intervals, the encoding odd-bit signals at the first 2 bits may be determined based on the PAM3 signal in a 1^{st} unit interval, and the encoding even-bit signals at the last 2 bits are determined based on the PAM3 signal in a 2^{nd} unit interval.

In a possible implementation of the second aspect, the method further includes: determining a serial bitstream based on the plurality pieces of 3-bit data. In the foregoing possible implementation, the serial bitstream may be determined based on the plurality of pieces of 3-bit data obtained through decoding, to implement encoding, decoding, and transmission of the serial bitstream.

According to a third aspect, an encoding apparatus is provided. The apparatus includes: an encoder, configured to obtain to-be-encoded 3-bit data; and encode the 3-bit data, to obtain a 4-bit encoded parity signal, where the 3-bit data includes first bit data A, second bit data B, and third bit data C, and the 4-bit encoded parity signal includes a first encoded odd-bit signal S1, a second encoded odd-bit signal S2, a first encoded even-bit signal S3, and a second encoded even-bit signal S4 that satisfy *S*1=*A•*(*B+C*), *S*2=*A̅•*(*B+C̅*), *S*3=(*A̅+B̅*)*•C*, and *S*4=(*A*+*B̅*)•*C̅*, where • indicates logical AND, + indicates logical OR, *A̅* indicates an inverted phase of A, *B̅* indicates an inverted phase of B, and *C̅* indicates an inverted phase of C; and a driver, configured to generate a PAM3 signal in two unit intervals based on the 4-bit encoded parity signal, and send the PAM3 signal.

In a possible implementation of the third aspect, the encoder is further configured to: if the 3-bit data is 111, encode 111, to obtain a 4-bit encoded parity signal 1000; if the 3-bit data is 110, encode 110, to obtain a 4-bit encoded parity signal 1001; if the 3-bit data is 001, encode 001, to obtain a 4-bit encoded parity signal 0010; if the 3-bit data is 101, encode 101, to obtain a 4-bit encoded parity signal 1010; if the 3-bit data is 100, encode 100, to obtain a 4-bit encoded parity signal 0001; if the 3-bit data is 011, encode 011, to obtain a 4-bit encoded parity signal 0110; if the 3-bit data is 010, encode 010, to obtain a 4-bit encoded parity signal 0100; and if the 3-bit data is 000, encode 000, to obtain a 4-bit encoded parity signal 0101.

In a possible implementation of the third aspect, the encoded odd-bit signals at the first 2 bits of the 4-bit encoded parity signal are used to generate a PAM3 signal in a 1^{st} unit interval, and the encoded even-bit signals at the last 2 bits are used to generate a PAM3 signal in a 2^{nd} unit interval.

In a possible implementation of the third aspect, the apparatus further includes: a shift register, configured to receive a serial bitstream, and divide the serial bitstream into a plurality of pieces of 3-bit data at a granularity of 3 bits, where the to-be-encoded 3-bit data is any one of the plurality of pieces of 3-bit data.

According to a fourth aspect, a decoding apparatus is provided. The apparatus includes: a comparator, configured to: obtain a three-level pulse amplitude modulation PAM3 signal in two unit intervals; and determine a 4-bit decoding parity signal based on the PAM3 signal in the two unit intervals; and a decoder, configured to decode the 4-bit decoding parity signal, to obtain 3-bit data, where if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000.

In a possible implementation of the fourth aspect, the 4-bit decoding parity signal includes a first decoding odd-bit signal C1, a second decoding odd-bit signal C2, a first decoding even-bit signal C3, and a second decoding even-bit signal C4, and the 3-bit data includes first bit data A, second bit data B, and third bit data C that satisfy *A*=*C*1*+*(*̅C̅*̅3̅•*C*2), *B*=(*̅C̅*̅3̅•*C*4)*+*(*̅C̅*̅3̅•*C*1)*+*(*̅C̅*̅2̅•*C*4), and *C*=*C*3*+C*4*•C*2, where • indicates logical AND, + indicates logical OR, C3 indicates an inverted phase of C3, and C2 indicates an inverted phase of C2.

In a possible implementation of the fourth aspect, the decoding odd-bit signals at the first 2 bits of the 4-bit decoding parity signal are determined based on a PAM3 signal in a 1^{st} unit interval, and the decoding even-bit signals at the last 2 bits are determined based on a PAM3 signal in a 2^{nd} unit interval.

In a possible implementation of the fourth aspect, the apparatus further includes: a shift register, configured to determine a serial bitstream based on the plurality pieces of 3-bit data obtained through decoding.

According to a fifth aspect, a chiplet interconnection system is provided. The chiplet interconnection system includes a first chiplet and a second chiplet that are coupled, the first chiplet includes the encoding apparatus provided in the third aspect or any one of the possible implementations of the third aspect, and the second chiplet includes the decoding apparatus provided in the fourth aspect or any one of the possible implementations of the fourth aspect.

According to a sixth aspect, a data transmission method is provided, and is applied to a chiplet interconnection system including a first chiplet and a second chiplet. The method includes: The first chiplet obtains to-be-encoded 3-bit data, and encodes the to-be-encoded 3-bit data, to obtain a 4-bit encoded parity signal, where the 3-bit data includes first bit data A, second bit data B, and third bit data C, and the 4-bit encoded parity signal includes a first encoded odd-bit signal S1, a second encoded odd-bit signal S2, a first encoded even-bit signal S3, and a second encoded even-bit signal S4 that satisfy *S*1=*A•*(*B+C*), *S*2=*A̅•*(*B+C̅*)*, S*3=(*A̅+B̅*)•*C*, and *S*4=(*A+B̅*)•*C̅*, where • indicates logical AND, + indicates logical OR, *A̅* indicates an inverted phase of A, B indicates an inverted phase of B, and C indicates an inverted phase of C. The first chiplet generates a three-level pulse amplitude modulation PAM3 signal in two unit intervals based on the 4-bit encoded parity signal, and sends the PAM3 signal. The second chiplet obtains the PAM3 signal in the two unit intervals, and determines a 4-bit decoding parity signal based on the PAM3 signal in the two unit intervals. The second chiplet decodes the 4-bit decoding parity signal, to obtain the 3-bit data, where if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000.

In a possible implementation of the sixth aspect, that the first chiplet encodes the 3-bit data, to obtain a 4-bit encoded parity signal includes: if the 3-bit data is 111, encoding 111, to obtain a 4-bit encoded parity signal 1000; if the 3-bit data is 110, encoding 110, to obtain a 4-bit encoded parity signal 1001; if the 3-bit data is 001, encoding 001, to obtain a 4-bit encoded parity signal 0010; if the 3-bit data is 101, encoding 101, to obtain a 4-bit encoded parity signal 1010; if the 3-bit data is 100, encoding 100, to obtain a 4-bit encoded parity signal 0001; if the 3-bit data is 011, encoding 011, to obtain a 4-bit encoded parity signal 0110; if the 3-bit data is 010, encoding 010, to obtain a 4-bit encoded parity signal 0100; and if the 3-bit data is 000, encoding 000, to obtain a 4-bit encoded parity signal 0101.

In a possible implementation of the sixth aspect, the 4-bit decoding parity signal includes a first decoding odd-bit signal C1, a second decoding odd-bit signal C2, a first decoding even-bit signal C3, and a second decoding even-bit signal C4, and the 3-bit data includes first bit data A, second bit data B, and third bit data C that satisfy *A*=*C*1*+*(*̅C̅*̅3̅•*C*2), *B*=(*̅C̅*̅3̅•*C*4)*+*(*̅C̅*̅3̅•*C*1)*+*(*̅C̅*̅2̅•*C*4), and *C*=*C*3*+C*4•*C*2, where • indicates logical AND, + indicates logical OR, C3 indicates an inverted phase of C3, and C2 indicates an inverted phase of C2.

In a possible implementation of the sixth aspect, the encoded odd-bit signals at the first 2 bits of the 4-bit encoded parity signal are used to generate a PAM3 signal in a 1^{st} unit interval, and the encoded even-bit signals at the last 2 bits are used to generate a PAM3 signal in a 2^{nd} unit interval.

In a possible implementation of the sixth aspect, the decoding odd-bit signals at the first 2 bits of the 4-bit decoding parity signal are determined based on a PAM3 signal in a 1^{st} unit interval, and the decoding even-bit signals at the last 2 bits are determined based on a PAM3 signal in a 2^{nd} unit interval.

In a possible implementation of the sixth aspect, that the first chiplet obtains to-be-encoded 3-bit data includes: The first chiplet receives a serial bitstream, and divides the serial bitstream into a plurality of pieces of 3-bit data at a granularity of 3 bits, where the to-be-encoded 3-bit data is any one of the plurality of pieces of 3-bit data.

In a possible implementation of the sixth aspect, after the second chiplet decodes the 4-bit decoding parity signal, to obtain the 3-bit data, the method further includes: The second chiplet determines the serial bitstream based on the plurality of pieces of 3-bit data obtained through decoding.

It may be understood that any one of the encoding apparatus, the decoding apparatus, the chiplet interconnection system, and the data transmission method includes content of performing the corresponding encoding method or decoding method provided above. Therefore, for beneficial effect that can be achieved, refer to the beneficial effect in the corresponding methods provided above. Details are not described herein again.

### BRIEF DESCRIPTION OF DRAWINGS

FIG. 1 is a diagram of data transmission based on PAM3 coding;
FIG. 2 is a state diagram of decoding logic of a PAM3 signal;
FIG. 3 is a schematic flowchart of an encoding method according to an embodiment of this application;
FIG. 4 is a schematic flowchart of a decoding method according to an embodiment of this application;
FIG. 5 is a diagram of a structure of a comparator according to an embodiment of this application;
FIG. 6 is a state diagram of decoding logic of a PAM3 signal according to an embodiment of this application;
FIG. 7 is a schematic flowchart of a data transmission method according to an embodiment of this application;
FIG. 8 is a diagram of a structure of an encoding apparatus according to an embodiment of this application; and
FIG. 9 is a diagram of a structure of a decoding apparatus according to an embodiment of this application.

### DESCRIPTION OF EMBODIMENTS

The making and use of embodiments are discussed in detail below. It should be appreciated, however, that a plurality of applicable inventive concepts provided in this application may be implemented in a plurality of specific environments. The specific embodiments discussed are merely illustrative of specific ways to implement and use this description and this technology, and do not limit the scope of this application.

Unless otherwise defined, all technical terms used herein have the same meaning as those commonly known to a person of ordinary skill in the art.

Circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not opened), the circuit/component may also be referred to as being configured to perform the task. Circuits/components used in conjunction with the "configured to" phrase include hardware, for example, a circuit for performing an operation.

The following describes technical solutions in embodiments of this application with reference to accompanying drawings in embodiments of this application. In this application, "at least one" refers to one or more, "a plurality of" refers to two or more, and "and/or" describes an association relationship between associated objects, and indicates that three relationships may exist. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one item (piece) of the following" or a similar expression thereof means any combination of these items, including a singular item (piece) or any combination of plural items (pieces). For example, at least one of a, b, or c may represent: a, b, c, a and b, a and c, b and c, or a, b, and c, where a, b, and c may be singular or plural.

In embodiments of this application, words such as "first" and "second" are used to distinguish between objects with similar names or functions or effect. A person skilled in the art may understand that the words such as "first" and "second" do not limit a quantity and an execution sequence. The term "coupling" is used for representing an electrical connection, including a direct connection through a wire or a connection end or an indirect connection through another device. Therefore, "coupling" should be considered as a generalized electronic communication connection.

In this application, words such as "for example" or "such as" indicate an example, an instance, or descriptions. Any embodiment or design scheme described as "example" or "for example" in this application should not be explained as being more preferred or having more advantages than another embodiment or design scheme. To be precise, use of the word like "for example" or "such as" is intended to present a relative concept in a specific manner.

Technical solutions provided in this application may be applied to a chiplet (chiplet) interconnection system. The chiplet interconnection system may include a plurality of chiplets, data transmission may be performed between different chiplets in the plurality of chiplets, and a channel used for data transmission may be referred to as an interconnection channel. During actual application, the chiplet interconnection system may be applied to a communication device, and each of the plurality of chiplets may correspond to one or more functional circuits in the communication device. For example, the plurality of chiplets may include one or more of a processor, a memory, a radio frequency (radio frequency, RF) circuit, a display driver circuit, a sensor, an audio circuit, an input/output interface, and the like in the communication device. The communication device includes but is not limited to a mobile phone, a tablet computer, a computer, a notebook computer, a video camera, a camera, a wearable device, a vehicle-mounted device (for example, a car, a bicycle, an electric vehicle, an airplane, a ship, a train, or a high-speed railway), a virtual reality (virtual reality, VR) device, an augmented reality (augmented reality, AR) device, an intelligent robot, or the like.

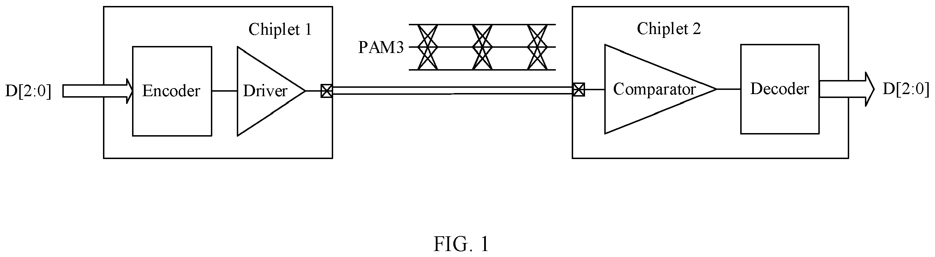

Currently, in the chiplet (chiplet) interconnection system, to increase a signal transmission bandwidth while ensuring that a Baud rate remains unchanged, three-level pulse amplitude modulation (three-level pulse amplitude modulation, PAM3) coding is usually used, to transmit 3-bit (bits) data in two unit intervals (unit interval, UI) through the interconnection channel. For example, as shown in FIG. 1, an example in which data is transmitted between two chiplets (which are respectively represented as a chiplet 1 and a chiplet 2) in the chiplet interconnection system based on PAM3 coding is used. The chiplet 1, as a transmit end, may perform PAM3 encoding on to-be-sent 3-bit data D[2:0], to obtain a PAM3 signal in two UIs, and send the PAM3 signal in the two UIs to the chiplet 2. When receiving the PAM3 signal in the two UIs, the chiplet 2, as a receive end, may perform PAM3 decoding on the PAM3 signal in the two UIs, to obtain the 3-bit data D[2:0]. In FIG. 1, an example in which the chiplet 1 includes an encoder and a driver, and the chiplet 2 includes a comparator and a decoder is used for description. During actual application, one chiplet may alternatively include encoding/decoding-related components such as an encoder, a driver, a comparator, and a decoder. A structure of the chiplet shown in FIG. 1 is merely an example, and constitutes no limitation on embodiments of this application. The UI is time occupied by a bit to transmit information, and a slot of one code unit is one UI.

With reference to FIG. 1, the following describes in detail two types of encoding/decoding logic related to current PAM3.

### First type of PAM3 encoding/decoding logic

The transmit end includes an encoder and a driver. The transmit end divides to-be-sent data into a plurality of groups at a granularity of 3 bits by using the encoder, and generates a parity signal with a group of 4 bits [UPo, DNo, UP_{E}, DN_{E}] based on one group of data [A, B, C] and encoding logic shown in the following formula (1-1). The 4-bit parity signal is used to control the driver to generate a PAM3 signal in two UIs. [UPo, DNo] is used to control generation of a PAM3 signal at an odd bit (that is, in a 1^{st} UI), and [UP_{E}, DN_{E}] is used to control generation of a PAM3 signal at an even bit (that is, in a 2^{nd} UI). The PAM3 signal has three levels (namely, a high level, a middle level, and a low level). [UP, DN] has four states: [1, 0], [1, 1], and [0, 1] that are respectively used to control generation of the three levels of the PAM3 signal; and [0, 0] that is an invalid state. In the formula (1-1), + indicates logical OR, *U̅P̅_̅{̅O̅}̅* indicates an inverted phase of UPo, *U̅P̅_̅{̅E̅}̅* indicates an inverted phase of UP_{E}, and *C̅* indicates an inverted phase of C. $\begin{matrix}\overline{{UP}_{O}} = B \overline{C} \\ {DN}_{O} = A + B \overline{C} \\ \overline{{UP}_{E}} = B \left(A+C\right) \\ {DN}_{E} = C + B \overline{C}\end{matrix}$

Correspondingly, the receive end includes two comparators. A threshold voltage of a high-threshold comparator is an average value VTH_H of a voltage value corresponding to the high level and a voltage value corresponding to the middle level of the PAM3 signal, and the high-threshold comparator outputs Comp_{ODD_H} and Comp_{EVEN_H} that respectively correspond to an odd bit and an even bit of the PAM3 signal. A threshold voltage of a low-threshold comparator is an average value VTH_L of a voltage value corresponding to the low level and the voltage value corresponding to the middle level of the PAM3 signal, and the low-threshold comparator outputs Comp_{ODD_L} and Comp_{EVEN_L} that respectively correspond to the odd bit and the even bit of the PAM3 signal. The 4-bit signal [Comp_{ODD_H}, Comp_{ODD_L}, Comp_{EVEN_H}, Comp_{EVEN_L}] output by the two comparators is used to control the decoder to perform decoding based on decoding logic shown in the following formula (1-2), to obtain the original 3-bit data [A, B, C]. In the formula (1-2), + indicates logical OR, *i* indicates an inverted phase of *i,* and *i* may be Comp_{ODD_H}, Comp_{EVEN_H}, or Comp_{EVEN_L}. $\begin{matrix}A = \overline{{Comp}_{ODD _ H}} \left({Comp}_{ODD _ L}+\overline{{Comp}_{EVEN _ L}}\right) \\ B = \overline{{Comp}_{ODD _ L}} + \overline{{Comp}_{EVEN _ L}} \\ C = {Comp}_{ODD _ L} + \overline{{Comp}_{EVEN _ H}}\end{matrix}$

### Second type of PAM3 encoding/decoding logic

The transmit end divides to-be-sent data into a plurality of groups at a granularity of 3 bits by using the encoder, and generates a parity signal with a group of 4 bits [Ho, Lo, H_{E}, L_{E}] based on one group of data [A, B, C] and encoding logic shown in the following formula (2-1). The 4-bit parity signal is used to control the driver to generate a PAM3 signal in two UIs. [Ho, Lo] is used to control generation of a PAM3 signal at an odd bit (that is, in a 1^{st} UI), and [H_{E}, L_{E}] is used to control generation of a PAM3 signal at an even bit (that is, in a 2^{nd} UI). The PAM3 signal has three levels (namely, a high level, a middle level, and a low level). [UP, DN] has four states: [1, 0], [1, 1], and [0, 1] that are respectively used to control generation of the three levels of the PAM3 signal; and [0, 0] that is an invalid state. In the formula (2-1), + indicates logical OR, *i̅* indicates an inverted phase of *i,* and *i* may be A, B, or C. $\begin{matrix}{H}_{O} = AB \\ {L}_{O} = \overline{A} \left(B+\overline{C}\right) \\ {H}_{E} = \overline{A} C \\ {L}_{E} = \overline{C} \left(A+\overline{B}\right)\end{matrix}$

The receive end includes two comparators: a high-threshold comparator and a low-threshold comparator. The two comparators output the 4-bit signal [Comp_{ODD_H}, Comp_{ODD_L}, Comp_{EVEN_H}, Comp_{EVEN_L}] based on the received PAM3 signal in the two UIs. The decoder at the receive end decodes the 4-bit signal based on decoding logic shown in the following formula (2-2), to obtain the original 3-bit data [A, B, C]. In the formula (2-2), • indicates logical AND, + indicates logical OR, *i* indicates an inverted phase of *i,* and *i* may be Comp_{ODD_L} or Comp_{EVEN_H}. $\begin{matrix}A = {Comp}_{ODD _ L} \cdot \overline{{Comp}_{EVEN _ H}} \\ B = \overline{{Comp}_{ODD _ L}} \cdot {Comp}_{EVEN _ L} + {Comp}_{ODD _ H} \\ C = {Comp}_{ODD _ L} \cdot {Comp}_{EVEN _ L} + {Comp}_{EVEN _ H}\end{matrix}$

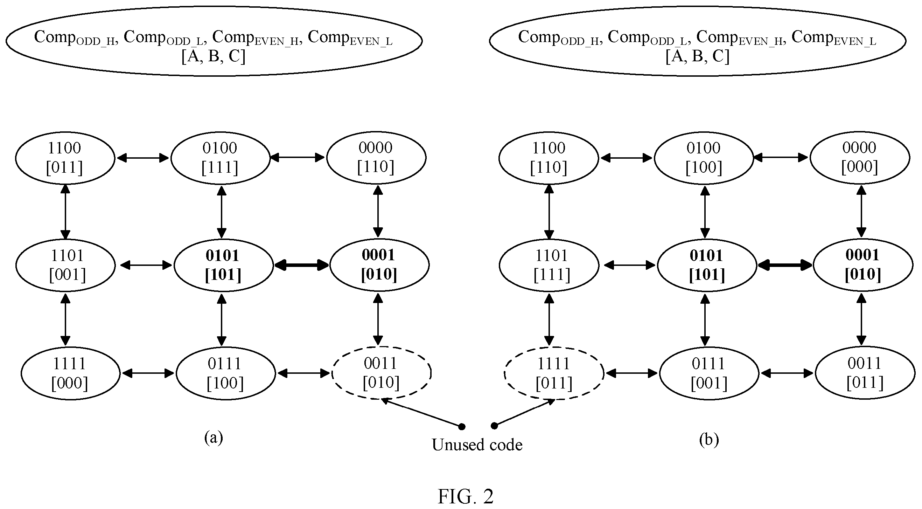

(a) and (b) in FIG. 2 are state diagrams of the foregoing two types of decoding logic, that is, state diagrams including the 4-bit signal [Comp_{ODD_H}, Comp_{ODD_L}, Comp_{EVEN_H}, Comp_{EVEN_L}] and the 3-bit data [A, B, C] obtained through decoding in the decoding logic. If a bit error in one UI occurs in any state shown in the state diagram of the decoding logic, a current state may be jumped to an adjacent state. A state 0101 [101] shown in (a) in FIG. 2 is used as an example. If a bit error in one UI occurs, the state may be jumped to 0100 [111], 0111 [100], 1101 [001], or 0001 [010].

In the foregoing two types of PAM3 encoding/decoding logic, the original 3-bit data is obtained by decoding the PAM3 signal in the two UIs. If a bit error in one UI occurs in the PAM3 signal in the two UIs, a bit error in a maximum of 3 bits may occur in the restored original data, and a bit error rate is high. For example, if an error occurs in a signal at a level in the PAM3 signal, the signal may be incorrectly determined as signals at the other two levels. For example, the receive end correctly samples a signal at a middle level, to obtain data [0, 1]. If the signal is incorrectly determined as signals at the other two levels, the data obtained through sampling may be [0, 0] or [1, 1]. The receive end correctly samples a signal at a low level, to obtain data [0, 0]. If the signal is incorrectly determined as signals at the other two levels, the data obtained through sampling may be [0, 1] or [1, 1]. The receive end correctly samples a signal at a high level, to obtain data [1, 1]. If the signal is incorrectly determined as signals at the other two levels, the data obtained through sampling may be [0, 1] or [0, 0]. Consequently, after a bit error in one UI in a channel is decoded, a bit error may occur in a maximum of 3-bit data. For example, a group of data [1, 0, 1] may be incorrectly determined as [0, 1, 0], and a group of data [0, 1, 0] may be incorrectly determined as [1, 0, 1].

In view of this, an embodiment of this application provides a PAM3 encoding/decoding method. When a bit error of a PAM3 signal in one UI occurs in a PAM3 signal in two UIs, and a 4-bit decoding parity signal determined based on the PAM3 signal in the two UIs is used for decoding, encoding/decoding logic is used in the encoding/decoding method, to ensure that a bit error occurs in a maximum of 2 bits in 3-bit data obtained through decoding. In this case, in comparison with a bit error in a maximum of 3-bit data in the foregoing related technology, a bit error rate is low.

A 4-bit encoded parity signal mentioned below is a 4-bit signal, and a 4-bit decoding parity signal is also a 4-bit signal. The 4-bit encoded parity signal and the 4-bit decoding parity signal may also be referred to as parity signals. The parity signal may be an odd (odd, O)-bit signal and an even (even, E)-bit signal that occupy two UIs in a transmission process. The odd-bit signal includes an odd-bit signal at a high (high, H) bit and an odd-bit signal at a low (low, L) bit. The even-bit signal includes an even-bit signal at a high (high, H) bit and an even-bit signal at a low bit. When the parity signal is used for encoding, the parity signal may be referred to as a 4-bit encoded parity signal or an encoded parity signal. When the parity signal is used for decoding, the parity signal may be referred to as a 4-bit decoding parity signal or a decoding parity signal. In addition, the parity signal may also be referred to as a control signal. When the control signal is used for encoding, the control signal may be used to control a driver at a transmit end to generate a PAM3 signal in two UIs. In this case, the control signal may also be referred to as a 4-bit encoded control signal or an encoded control signal. When the control signal is used for decoding, the control signal may be used to control a decoder at a receive end to perform decoding, to obtain 3-bit data. In this case, the control signal may also be referred to as a 4-bit encoding/decoding signal or a decoding control signal.

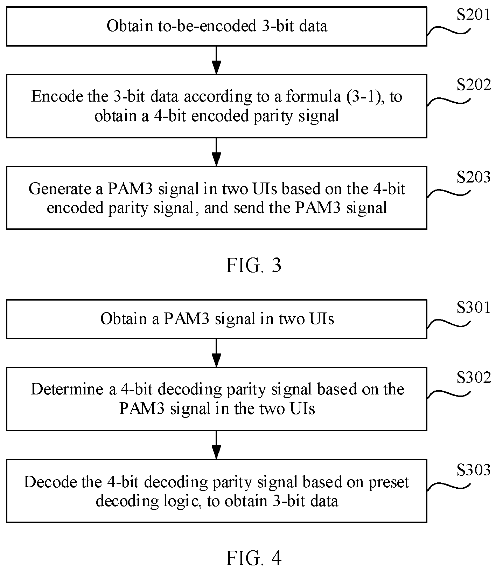

FIG. 3 is a schematic flowchart of an encoding method according to an embodiment of this application. The method may be applied to a chiplet interconnection system, and may be specifically performed by a chiplet used as a transmit end in the chiplet interconnection system. The method includes the following steps.

S201: Obtain to-be-encoded 3-bit data.

The to-be-encoded 3-bit data may be data of consecutive 3 bits in a to-be-sent data stream. The to-be-sent data stream may be generated by the chiplet. For example, an upper-layer application running on the chiplet may generate the to-be-sent data stream. Optionally, the data stream may be a serial bit data stream.

In a possible embodiment, the obtaining to-be-encoded 3-bit data may include: receiving the serial bitstream, and dividing the serial bitstream into a plurality of pieces of 3-bit data at a granularity of 3 bits, where the to-be-encoded 3-bit data is any one of the plurality of pieces of 3-bit data.

Optionally, the chiplet may include a shift register. The shift register may be configured to receive the serial bitstream, and divide the serial bitstream into the plurality of pieces of 3-bit data at the granularity of 3 bits through a shift operation, that is, every three pieces of serial bit data is converted into three pieces of parallel bit data through serial-to-parallel conversion.

S202: Encode the 3-bit data according to a formula (3-1), to obtain a 4-bit encoded parity signal.

The 3-bit data includes first bit data A, second bit data B, and third bit data C, and the 4-bit encoded parity signal includes a first encoded odd-bit signal S1, a second encoded odd-bit signal S2, a first encoded even-bit signal S3, and a second encoded even-bit signal S4 that satisfy the following formula (3-1). • indicates logical AND, + indicates logical OR, *A̅* indicates an inverted phase of A, *B̅* indicates an inverted phase of B, and *C̅* indicates an inverted phase of C. $\begin{matrix}S 1 = A \cdot \left(B+C\right) \\ S 2 = \overline{A} \cdot \left(B+\overline{C}\right) \\ S 3 = \left(\overline{A}+\overline{B}\right) \cdot C \\ S 4 = \left(A+\overline{B}\right) \cdot \overline{C}\end{matrix}$

The 3-bit data may include eight states: 111, 110, 001, 101, 100, 011, 010, and 000. The different states of the 3-bit data are encoded according to the formula (3-1), to correspondingly obtain eight states of the 4-bit encoded parity signal: 1000, 1001, 0010, 1010, 0001, 0110, 0100, and 0101.

Specifically, when the 3-bit data is encoded according to the formula (3-1) to obtain the 4-bit encoded parity signal, the 3-bit data and the 4-bit encoded parity signal satisfy states shown in Table 1. If the 3-bit data is 111, the 4-bit encoded parity signal is 1000; if the 3-bit data is 110, the 4-bit encoded parity signal is 1001; if the 3-bit data is 001, the 4-bit encoded parity signal is 0010; if the 3-bit data is 101, the 4-bit encoded parity signal is 1010; if the 3-bit data is 100, the 4-bit encoded parity signal is 0001; if the 3-bit data is 011, the 4-bit encoded parity signal is 0110; if the 3-bit data is 010, the 4-bit encoded parity signal is 0100; and if the 3-bit data is 000, the 4-bit encoded parity signal is 0101.

In a possible embodiment, the encoded odd-bit signals at the first 2 bits of the 4-bit encoded parity signal may be used to generate a PAM3 signal in a 1^{st} UI, and the encoded even-bit signals at the last 2 bits are used to generate a PAM3 signal in a 2^{nd} UI. The 1^{st} UI may also be referred to as an odd (odd, O) bit of the PAM3 signal, and the 2^{nd} UI may also be referred to as an even (even, E) bit of the PAM3 signal.

Optionally, S1 and S2 are the encoded odd-bit signals at the first 2 bits, S1 may be an encoded odd-bit signal corresponding to a high (high, H) bit and may be represented as THo, and S2 may be an encoded odd-bit signal corresponding to a low (low, L) bit and may be represented as TLo. S3 and S4 are the encoded even-bit signals at the last 2 bits, S3 may be an encoded even-bit signal corresponding to a high bit and may be represented as TH_{E}, and S4 may be an encoded even-bit signal corresponding to a low bit and may be represented as TL_{E}. Therefore, the formula (3-1) may be correspondingly represented as a formula (3-1'). $\begin{matrix}{TH}_{O} = A \cdot \left(B+C\right) \\ {TL}_{O} = \overline{A} \cdot \left(B+\overline{C}\right) \\ {TH}_{E} = \left(\overline{A}+\overline{B}\right) \cdot C \\ {TL}_{E} = \left(A+\overline{B}\right) \cdot \overline{C}\end{matrix}$

Optionally, the chiplet may further include an encoder. The encoder may be configured to receive the 3-bit data [A, B, C], and encode the received 3-bit data [A, B, C] according to the formula (3-1), to obtain the 4-bit encoded parity signal [TH_{O}, TL_{O}, TH_{E}, TL_{E}]. Further, the chiplet may further include a selector. The selector may be configured to select, in the 1^{st} UI from the 4-bit encoded parity signal, the encoded odd-bit signals THo and TLo that are at the first 2 bits for output, and select, in the 2^{nd} UI from the 4-bit encoded parity signal, the encoded even-bit signals TH_{E} and TL_{E} that are at the last 2 bits for output.

S203: Generate a PAM3 signal in two UIs based on the 4-bit encoded parity signal, and send the PAM3 signal.

The unit interval UI is time occupied by a bit to transmit information, and a slot of one code unit is one UI.

In a possible embodiment, when determining the 4-bit encoded parity signal, the chiplet may generate, in the 1^{st} UI, the PAM3 signal in the 1^{st} UI based on the encoded odd-bit signals [THo, TLo] that are at the first 2 bits and send the PAM3 signal in the 1^{st} UI, and generate, in the 2^{nd} UI, the PAM3 signal in the 2^{nd} UI based on the encoded even-bit signals [TH_{E}, TL_{E}] that are at the last 2 bits and send the PAM3 signal in the 2^{nd} UI, to generate the three-level pulse amplitude modulation PAM3 signal in the two UIs and send the PAM3 signal.

For example, the PAM3 signal has three levels. For example, the PAM3 signal in the 1^{st} UI is generated based on [THo, TLo]. If a state of [THo, TLo] is [1, 0], the generated PAM3 signal is at a high level. If the state of [THo, TLo] is [1, 1], the generated PAM3 signal is at a middle level. If the state of [THo, TLo] is [0, 1], the generated PAM3 signal is at a low level. Similarly, a principle of generating the PAM3 signal in the 2^{nd} UI based on [TH_{E}, TL_{E}] is similar to a principle of generating the PAM3 signal in the 1^{st} UI based on [THo, TLo]. Details are not described again in embodiments of this application. During actual application, for the foregoing several states corresponding to [THo, TLo], different levels of the PAM3 signal may alternatively be generated according to another correspondence. For example, when the state of [THo, TLo] is [1, 1], the generated PAM3 signal may be at a high level. When the state of [THo, TLo] is [1, 0], the generated PAM3 signal may be at a middle level. The foregoing examples have no limitation on embodiments of this application.

Optionally, the chiplet may also include a driver. The driver may generate, in the 1^{st} UI, the PAM3 signal in the 1^{st} UI based on the encoded odd-bit signals [THo, TLo] that are at the first 2 bits and send the PAM3 signal in the 1^{st} UI, and generate, in the 2^{nd} UI, the PAM3 signal in the 2^{nd} UI based on the encoded even-bit signals [TH_{E}, TL_{E}] that are at the last 2 bits and send the PAM3 signal in the 2^{nd} UI. For specific descriptions of the driver, refer to descriptions in the related technology. Details are not described in embodiments of this application.

For ease of understanding, the following describes, by using Table 1, states corresponding to the 3-bit data, the 4-bit encoded parity signal, and the PAM3 signal in the two UIs in the encoding method provided in this application. In Table 1, an example in which the 4-bit encoded parity signal is [THo, TLo, TH_{E}, TL_{E}] is used for description.

**Table 1**

| Sequential number | 3-bit data | | | 4-bit encoded parity signal | | | | PAM3 signal in two UIs |
|---|---|---|---|---|---|---|---|---|
| | A | B | C | TH_{O} | TL_{O} | TH_{E} | TL_{E} | |
| 1 | 1 | 1 | 1 | 1 | 0 | 0 | 0 | 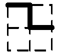 |
| 2 | 1 | 1 | 0 | 1 | 0 | 0 | 1 | 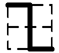 |
| 3 | 0 | 0 | 1 | 0 | 0 | 1 | 0 | 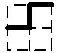 |
| 4 | 1 | 0 | 1 | 1 | 0 | 1 | 0 | 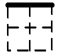 |
| 5 | 1 | 0 | 0 | 0 | 0 | 0 | 1 | 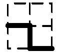 |
| 6 | 0 | 1 | 1 | 0 | 1 | 1 | 0 | 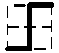 |
| 7 | 0 | 1 | 0 | 0 | 1 | 0 | 0 | 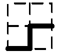 |
| 8 | 0 | 0 | 0 | 0 | 1 | 0 | 1 | 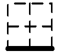 |

In the encoding method provided in embodiments of this application, when the to-be-encoded 3-bit data is obtained, the to-be-encoded 3-bit data is encoded based on encoding logic that the 3-bit data and the 4-bit encoded parity signal satisfy, to obtain the 4-bit encoded parity signal. When the PAM3 signal in the two unit intervals that is generated based on the 4-bit encoded parity signal is sent to a receive end, it can be ensured that the receive end decodes the PAM3 signal based on specific decoding logic, to obtain the 3-bit data with a low bit error rate.

FIG. 4 is a schematic flowchart of a decoding method according to an embodiment of this application. The method may be applied to a chiplet interconnection system, and may be specifically performed by a chiplet used as a receive end in the chiplet interconnection system. The method includes the following steps.

S301: Obtain a PAM3 signal in two UIs.

In a possible embodiment, in the chiplet interconnection system, when two interconnected chiplets communicate with each other, the chiplet may be used as the receive end to receive the PAM3 signal in the two UIs from a transmit end.

S302: Determine a 4-bit decoding parity signal based on the PAM3 signal in the two UIs.

In a possible embodiment, when the chiplet obtains the PAM3 signal in the two UIs, the chiplet may determine, based on a PAM3 signal in a 1^{st} UI in the two UIs, decoding odd-bit signals at the first 2 bits, and determine, based on a PAM3 signal in a 2^{nd} UI in the two UIs, decoding even-bit signals at the last 2 bits, to determine the 4-bit decoding parity signal.

Optionally, the decoding odd-bit signals at the first 2 bits may include a decoding odd-bit signal at a high bit and a decoding odd-bit signal at a low bit, and the decoding even-bit signals at the last 2 bits may include a decoding even-bit signal at a high bit and a decoding even-bit signal at a low bit.

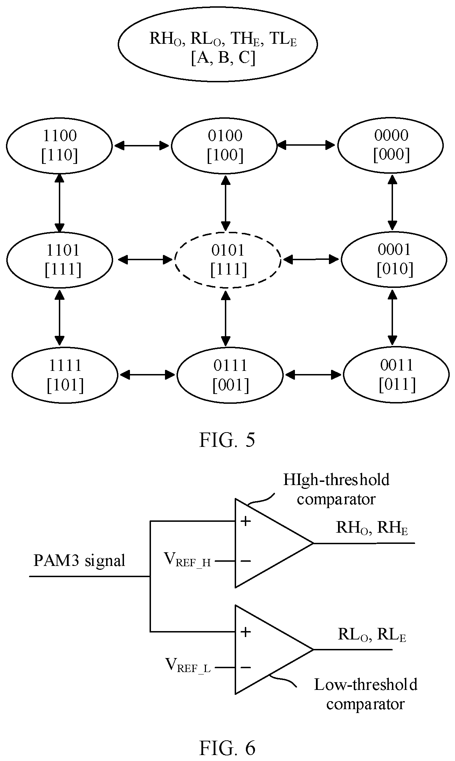

Optionally, the chiplet may include two comparators. The two comparators may be configured to determine the 4-bit decoding parity signal based on the PAM3 signal in the two UIs. For example, as shown in FIG. 5, the two comparators include a high-threshold comparator and a low-threshold comparator. A threshold voltage of the high-threshold comparator may be an average value V_{REF_H} of a voltage value corresponding to a high level of the PAM3 signal and a voltage value corresponding to a middle level of the PAM3 signal. The high-threshold comparator compares the PAM3 signal in the two UIs with V_{REF_H}, to output a decoding odd-bit signal at a high bit and a decoding even-bit signal at a high bit. A threshold voltage of the low-threshold comparator may be an average value V_{REF_L} of a voltage value corresponding to the middle level of the PAM3 signal and a voltage value corresponding to a low level of the PAM3 signal. The low-threshold comparator compares the PAM3 signal in the two UIs with V_{REF_L}, to output a decoding odd-bit signal at a low bit and a decoding even-bit signal at a low bit.

S303: Decode the 4-bit decoding parity signal based on preset decoding logic, to obtain 3-bit data.

The preset decoding logic satisfies that: if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000. The preset decoding logic may be represented in a plurality of different manners. The following uses examples for description.

In a possible embodiment, the 4-bit decoding parity signal includes a first decoding odd-bit signal C1, a second decoding odd-bit signal C2, a first decoding even-bit signal C3, and a second decoding even-bit signal C4, and the 3-bit data includes first bit data A, second bit data B, and third bit data C that satisfy the following formula (3-2). • indicates logical AND, + indicates logical OR, *̅C̅*̅2̅ indicates an inverted phase of C2, and *̅C̅*̅3̅ indicates an inverted phase of C3. $\begin{matrix}A = C 1 + \left(\overline{C 3}\cdot C2\right) \\ B = \left(\overline{C 3}\cdot C4\right) + \left(\overline{C 3}\cdot C1\right) + \left(\overline{C 2}\cdot C4\right) \\ C = C 3 + C 4 \cdot C 2\end{matrix}$

Optionally, C1 and C2 are the decoding odd-bit signals at the first 2 bits, C1 may be a decoding odd-bit signal corresponding to a high bit and may be represented as RHo, and C2 may be a decoding odd-bit signal corresponding to a low bit and may be represented as RLo. C3 and C4 are the decoding even-bit signals at the last 2 bits, C3 may be a decoding even-bit signal corresponding to a high bit and may be represented as RH_{E}, and C4 may be a decoding even-bit signal corresponding to a low bit and may be represented as RL_{E}. Therefore, the formula (3-2) may be correspondingly represented as a formula (3-2'). $\begin{matrix}A = {RH}_{O} + \left(\overline{{RH}_{E}}\cdot {RL}_{O}\right) \\ B = \left(\overline{R {H}_{E}}\cdot R{L}_{E}\right) + \left(\overline{R {H}_{E}}\cdot R{H}_{O}\right) + \left(\overline{R {L}_{O}}\cdot R{L}_{E}\right) \\ C = R {H}_{E} + R {L}_{E} \cdot R {L}_{O}\end{matrix}$

In another possible embodiment, the 4-bit decoding parity signal [RHo, RLo, RH_{E}, RL_{E}] and the 3-bit data [A, B, C] may further satisfy the following formula (3-3): • indicates logical AND, + indicates logical OR, *̅C̅*̅2̅ indicates an inverted phase of C2, and *̅C̅*̅3̅ indicates an inverted phase of C3. $\begin{matrix}A = {RH}_{O} \cdot {RL}_{O} + \left(\overline{{RH}_{E}}\cdot {RL}_{O}\right) \\ B = \left(\overline{R {H}_{E}}\cdot R{L}_{E}\right) + \left(\overline{R {H}_{E}}\cdot R{H}_{O}\right) + \left(\overline{R {L}_{O}}\cdot R{L}_{E}\right) \\ C = R {H}_{E} + R {L}_{E} \cdot R {L}_{O}\end{matrix}$

Optionally, the chiplet may further include a decoder. The decoder may be configured to: after receiving the 4-bit decoding parity signal output by the comparator, decode the 4-bit decoding parity signal [RHo, RLo, RH_{E}, RL_{E}] based on the preset decoding logic, to obtain the 3-bit data [A, B, C].

For ease of understanding, the following describes, by using Table 2, states corresponding to the PAM3 signal in the two UIs, the 4-bit decoding parity signal, and the 3-bit data in the decoding method provided in this application. In Table 2, an example in which the 4-bit decoding parity signal is [RHo, RLo, RH_{E}, RL_{E}] is used for description.

**Table 2**

| Sequential number | PAM3 signal in two UIs | 4-bit decoding parity signal | | | | 3-bit data | | |
|---|---|---|---|---|---|---|---|---|
| | | RH_{O} | RL_{O} | RH_{E} | RL_{E} | A | B | C |
| 1 | 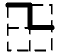 | 1 | 1 | 0 | 1 | 1 | 1 | 1 |
| 2 | 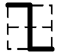 | 1 | 1 | 0 | 0 | 1 | 1 | 0 |
| 3 | 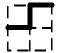 | 0 | 1 | 1 | 1 | 0 | 0 | 1 |
| 4 | 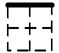 | 1 | 1 | 1 | 1 | 1 | 0 | 1 |
| 5 | 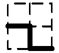 | 0 | 1 | 0 | 0 | 1 | 0 | 0 |
| 6 | 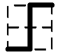 | 0 | 0 | 1 | 1 | 0 | 1 | 1 |
| 7 | 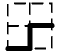 | 0 | 0 | 0 | 1 | 0 | 1 | 0 |
| 8 | 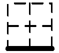 | 0 | 0 | 0 | 0 | 0 | 0 | 0 |
| 9 | | 0 | 1 | 0 | 1 | 1 | 1 | 1 |

FIG. 6 is a state diagram corresponding to the 4-bit decoding parity signal and the 3-bit data obtained through decoding in the decoding method according to this application, that is, a state diagram including the 4-bit decoding parity signal [RH_{O}, RL_{O}, RH_{E}, RL_{E}] and the 3-bit data [A, B, C] obtained through decoding in the decoding logic. If a bit error in one UI occurs in any state shown in the state diagram of the decoding logic, a current state may be jumped to an adjacent state.

It can be learned from Table 2 and FIG. 6 that the 4-bit decoding parity signal in the decoding logic provided in this application has nine states, and in the states 1101 and 0101, corresponding 3-bit data obtained through decoding is 111. With reference to Table 2 and FIG. 6, the following describes a case in which a bit error in one UI occurs in the PAM3 signal in the two UIs. In the following, bit data and a decoding parity signal in bold correspond to bit data and a decoding parity signal in which a bit error occurs.

When the PAM3 signal in the two UIs is the signal corresponding to the sequential number 1, the 4-bit decoding parity signal is 1101, and corresponding 3-bit data obtained through decoding is 111. If a bit error in one UI occurs, and consequently a bit error of 1 bit occurs in the 4-bit decoding parity signal, the 4-bit decoding parity signal may be 0101, 1100, or 1111, and corresponding 3-bit data obtained through decoding is 111, 110, or 101 respectively. If a bit error in one UI occurs, and consequently a bit error of 2 bits occurs in the 4-bit decoding parity signal, the 4-bit decoding parity signal is 0001, and corresponding 3-bit data obtained through decoding is 010.

When the PAM3 signal in the two UIs is the signal corresponding to the sequential number 2, the 4-bit decoding parity signal is 1100, and corresponding 3-bit data obtained through decoding is 110. If a bit error in one UI occurs, and consequently a bit error of 1 bit occurs in the 4-bit decoding parity signal, the 4-bit decoding parity signal may be 0100 or 1101, and corresponding 3-bit data obtained through decoding is 100 or 111 respectively. If a bit error in one UI occurs, and consequently a bit error of 2 bits occurs in the 4-bit decoding parity signal, the 4-bit decoding parity signal is 0000 or 1111, and corresponding 3-bit data obtained through decoding is 000 or 101 respectively.

When the PAM3 signal in the two UIs is the signal corresponding to the sequential number 3, the 4-bit decoding parity signal is 0111, and corresponding 3-bit data obtained through decoding is 001. If a bit error in one UI occurs, and consequently a bit error of 1 bit occurs in the 4-bit decoding parity signal, the 4-bit decoding parity signal may be 0011, 1111, or 0101, and corresponding 3-bit data obtained through decoding is 011, 101, or 111 respectively. If a bit error in one UI occurs, and consequently a bit error of 2 bits occurs in the 4-bit decoding parity signal, the 4-bit decoding parity signal may be 0100, and corresponding 3-bit data obtained through decoding is 100.

When the PAM3 signal in the two UIs is the signal corresponding to the sequential number 4, the 4-bit decoding parity signal is 1111, and corresponding 3-bit data obtained through decoding is 101. If a bit error in one UI occurs, and consequently a bit error of 1 bit occurs in the 4-bit decoding parity signal, the 4-bit decoding parity signal may be 0111, 1101, 0011, or 1100, and corresponding 3-bit data obtained through decoding is 001, 111, 011, or 110 respectively.

When the PAM3 signal in the two UIs is the signal corresponding to the sequential number 5, the 4-bit decoding parity signal is 0100, and corresponding 3-bit data obtained through decoding is 100. If a bit error in one UI occurs, and consequently a bit error of 1 bit occurs in the 4-bit decoding parity signal, the 4-bit decoding parity signal may be 0000, 1100, or 0101, and corresponding 3-bit data obtained through decoding is 000, 110, or 111 respectively. If a bit error in one UI occurs, and consequently a bit error of 2 bits occurs in the 4-bit decoding parity signal, the 4-bit decoding parity signal is 0111, and corresponding 3-bit data obtained through decoding is 001.

When the PAM3 signal in the two UIs is the signal corresponding to the sequential number 6, the 4-bit decoding parity signal is 0011, and corresponding 3-bit data obtained through decoding is 011. If a bit error in one UI occurs, and consequently a bit error of 1 bit occurs in the 4-bit decoding parity signal, the 4-bit decoding parity signal may be 0111 or 0001, and corresponding 3-bit data obtained through decoding is 001 or 010 respectively. If a bit error in one UI occurs, and consequently a bit error of 2 bits occurs in the 4-bit decoding parity signal, the 4-bit decoding parity signal is 1111 or 0000, and corresponding 3-bit data obtained through decoding is 101 or 000 respectively.

When the PAM3 signal in the two UIs is the signal corresponding to the sequential number 7, the 4-bit decoding parity signal is 0001, and corresponding 3-bit data obtained through decoding is 010. If a bit error in one UI occurs, and consequently a bit error of 1 bit occurs in the 4-bit decoding parity signal, the 4-bit decoding parity signal may be 0101 or 0011, and corresponding 3-bit data obtained through decoding is 111 or 011 respectively. If a bit error in one UI occurs, and consequently a bit error of 2 bits occurs in the 4-bit decoding parity signal, the 4-bit decoding parity signal is 1101, and corresponding 3-bit data obtained through decoding is 111.

When the PAM3 signal in the two UIs is the signal corresponding to the sequential number 8, the 4-bit decoding parity signal is 0000, and corresponding 3-bit data obtained through decoding is 000. If a bit error in one UI occurs, and consequently a bit error of 1 bit occurs in the 4-bit decoding parity signal, the 4-bit decoding parity signal may be 0100 or 0001, and corresponding 3-bit data obtained through decoding is 100 or 010 respectively. If a bit error in one UI occurs, and consequently a bit error of 2 bits occurs in the 4-bit decoding parity signal, the 4-bit decoding parity signal is 1100 or 0011, and corresponding 3-bit data obtained through decoding is 110 or 011 respectively.

It can be learned by analyzing different states of the PAM3 signal in the two UIs that, when a bit error occurs in a PAM3 signal in one UI in the PAM3 signal in the two UIs, in comparison with 3-bit data obtained by decoding a 4-bit decoding parity signal without a bit error, a difference exists in a maximum of 2-bit data in 3-bit data obtained by decoding a 4-bit decoding parity signal with a bit error, that is, a bit error occurs in a maximum of 2-bit data in the 3-bit data obtained through decoding by using the decoding method in this application. However, in the two types of decoding logic shown in FIG. 2, a bit error occurs in a maximum of 3-bit data.

Further, the chiplet may decode a received PAM3 signal in a plurality of UIs according to the decoding method provided in FIG. 4, to obtain a plurality of pieces of 3-bit data, and determine a serial bitstream based on the plurality of pieces of 3-bit data. For example, the chiplet may convert each of the plurality of pieces of 3-bit data from parallel data to serial data, to obtain the serial bitstream.

In the decoding method provided in embodiments of this application, the 4-bit decoding parity signal is determined based on the PAM3 signal in the two UIs, and the 4-bit decoding parity signal is decoded based on the preset decoding logic, to obtain the 3-bit data. In the foregoing process, when a bit error occurs in a PAM3 signal in one UI, in comparison with 3-bit data obtained by decoding a 4-bit decoding parity signal without a bit error, a difference exists in a maximum of 2-bit data in 3-bit data obtained by decoding a 4-bit decoding parity signal with a bit error. In this case, in comparison with a bit error in a maximum of 3-bit data in the related technology, a bit error rate is low.

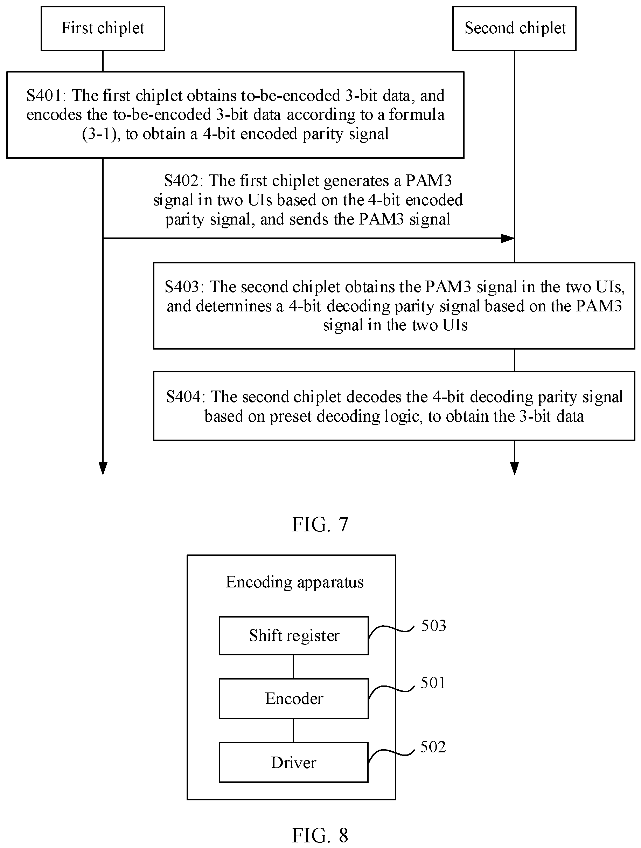

FIG. 7 is a schematic flowchart of a data transmission method according to an embodiment of this application. The method is applied to a chiplet interconnection system including a first chiplet and a second chiplet. The method includes the following steps.

S401: The first chiplet obtains to-be-encoded 3-bit data, and encodes the to-be-encoded 3-bit data according to a formula (3-1), to obtain a 4-bit encoded parity signal.

The 3-bit data includes first bit data A, second bit data B, and third bit data C, and the 4-bit encoded parity signal includes a first encoded odd-bit signal S1, a second encoded odd-bit signal S2, a first encoded even-bit signal S3, and a second encoded even-bit signal S4 that satisfy the following formula (3-1). • indicates logical AND, + indicates logical OR, *A̅* indicates an inverted phase of A, *B̅* indicates an inverted phase of B, and *C̅* indicates an inverted phase of C. $\begin{matrix}S 1 = A \cdot \left(B+C\right) \\ S 2 = \overline{A} \cdot \left(B+\overline{C}\right) \\ S 3 = \left(\overline{A}+\overline{B}\right) \cdot C \\ S 4 = \left(A+\overline{B}\right) \cdot \overline{C}\end{matrix}$

Further, that the first chiplet obtains to-be-encoded 3-bit data may include: The first chiplet receives a serial bitstream, and divides the serial bitstream into a plurality of pieces of 3-bit data at a granularity of 3 bits, where the to-be-encoded 3-bit data is any one of the plurality of pieces of 3-bit data.

S402: The first chiplet generates a PAM3 signal in two UIs based on the 4-bit encoded parity signal, and sends the PAM3 signal.

Optionally, the encoded odd-bit signals at the first 2 bits of the 4-bit encoded parity signal are used to generate a PAM3 signal in a 1^{st} UI, and the encoded even-bit signals at the last 2 bits are used to generate a PAM3 signal in a 2^{nd} UI.

S403: The second chiplet obtains the PAM3 signal in the two unit intervals, and determines a 4-bit decoding parity signal based on the PAM3 signal in the two UIs.

Optionally, the decoding odd-bit signals at the first 2 bits of the 4-bit decoding parity signal are determined based on the PAM3 signal in a 1^{st} UI, and the decoding even-bit signals at the last 2 bits are determined based on the PAM3 signal in a 2^{nd} UI.

S404: The second chiplet decodes the 4-bit decoding parity signal based on preset decoding logic, to obtain the 3-bit data.

The preset decoding logic satisfies that: if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000. The preset decoding logic may be represented in a plurality of different manners. The following uses examples for description.

In a possible embodiment, the 4-bit decoding parity signal includes a first decoding odd-bit signal C1, a second decoding odd-bit signal C2, a first decoding even-bit signal C3, and a second decoding even-bit signal C4, and the 3-bit data includes first bit data A, second bit data B, and third bit data C that satisfy the following formula (3-2). • indicates logical AND, + indicates logical OR, *̅C̅*̅2̅ indicates an inverted phase of C2, and *̅C̅*̅3̅ indicates an inverted phase of C3. $\begin{matrix}A = C 1 + \left(\overline{C 3}\cdot C2\right) \\ B = \left(\overline{C 3}\cdot C4\right) + \left(\overline{C 3}\cdot C1\right) + \left(\overline{C 2}\cdot C4\right) \\ C = C 3 + C 4 \cdot C 2\end{matrix}$

Further, the second chiplet may decode a received PAM3 signal in a plurality of UIs based on the foregoing steps, to obtain a plurality of pieces of 3-bit data, and determine a serial bitstream based on the plurality of pieces of 3-bit data. For example, the second chiplet may convert each of the plurality of pieces of 3-bit data from parallel data to serial data, to obtain the serial bitstream.

It should be noted that for related descriptions of the data transmission method, refer to specific descriptions of the encoding method and the decoding method provided above. Details are not described again in embodiments of this application.

In embodiments of this application, the first chiplet encodes the to-be-encoded 3-bit data based on encoding logic that the 3-bit data and the 4-bit encoded parity signal satisfy, to obtain the 4-bit encoded parity signal; and generates the PAM3 signal in the two UIs based on the 4-bit encoded parity signal, and send the PAM3 signal to the second chiplet. The second chiplet determines the 4-bit decoding parity signal based on the PAM3 signal in the two UIs, and decodes the 4-bit decoding parity signal based on the preset decoding logic, to obtain the 3-bit data. In the foregoing process, when a bit error occurs in a PAM3 signal in one UI, in comparison with 3-bit data obtained by decoding a 4-bit decoding parity signal without a bit error, a bit error occurs in a maximum of 2-bit data in 3-bit data obtained by decoding a 4-bit decoding parity signal with a bit error. In this case, in comparison with a bit error in a maximum of 3-bit data in the related technology, a bit error rate is low.

The foregoing mainly describes the solutions provided in embodiments of this application from a perspective of interaction between the chiplets. It may be understood that, to implement the foregoing functions, the chiplets used as a transmit end and a receive end include corresponding hardware structures and/or software modules for performing the functions. A person skilled in the art should easily be aware that, in combination with units and algorithm steps of the examples described in embodiments disclosed in this specification, this application may be implemented by hardware or a combination of hardware and computer software. Whether a function is executed by hardware or hardware driven by computer software depends on particular applications and design constraint conditions of the technical solutions. A person skilled in the art may use different methods to implement the described functions for each particular application, but it should not be considered that the implementation goes beyond the scope of this application.

In embodiments of this application, an encoding apparatus and a decoding apparatus may be divided into functional modules based on the foregoing method examples. For example, functional modules corresponding to the functions may be obtained through division, or two or more functions may be integrated into one module. The integrated module may be implemented in a form of hardware, or may be implemented in a form of a software functional module. It should be noted that, in embodiments of this application, division into the modules is an example, and is merely logical function division. During actual implementation, another division manner may be used. Descriptions are provided below by using an example in which each functional module is obtained through division based on each corresponding function.

FIG. 8 is a diagram of a possible structure of an encoding apparatus in the foregoing embodiments. The encoding apparatus may be a first chiplet used as a transmit end in a chiplet interconnection system, and the encoding apparatus includes an encoder 501 and a driver 502. The encoder 501 may be configured to support the apparatus in performing S201 and S202 in the method embodiment provided in FIG. 3, or performing S401 in the method embodiment provided in FIG. 7. The driver 502 may be configured to support the apparatus in performing S203 in the method embodiment provided in FIG. 3, or performing S402 in the method embodiment provided in FIG. 7. Further, the encoding apparatus may further include a shift register 503. The shift register 503 may be configured to support the apparatus in performing S201 in the method embodiment provided in FIG. 3, or performing the step of obtaining to-be-encoded 3-bit data in S401 in the method embodiment provided in FIG. 7. All related content of each step involved in the foregoing method embodiments may be referenced to a function description of a corresponding functional module. Details are not described herein again.

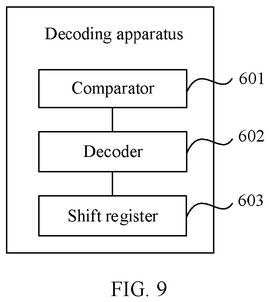

FIG. 9 is a diagram of a possible structure of a decoding apparatus in the foregoing embodiments. The decoding apparatus may be a second chiplet used as a transmit end in a chiplet interconnection system, and the decoding apparatus includes a comparator 601 and a decoder 602. The comparator 601 may be configured to support the apparatus in performing S301 and S302 in the method embodiment provided in FIG. 4, or performing S403 in the method embodiment provided in FIG. 7. The decoder 602 may be configured to support the apparatus in performing S303 in the method embodiment provided in FIG. 4, or performing S404 in the method embodiment provided in FIG. 7. Further, the decoder 602 may further include a shift register 603. The shift register 603 may be configured to support the apparatus in performing the step of determining a serial bitstream based on a plurality of pieces of 3-bit data in the method embodiment provided in FIG. 4 or FIG. 7. All related content of each step involved in the foregoing method embodiments may be referenced to a function description of a corresponding functional module. Details are not described herein again.

According to another embodiment of this application, a chiplet interconnection system is further provided. The chiplet interconnection system includes a first chiplet and a second chiplet that are interconnected. The first chiplet may include the encoding apparatus provided in FIG. 8, and is configured to perform encoding-related steps provided in the foregoing method embodiments. The second chiplet may include the decoding apparatus provided in FIG. 9, and is configured to perform decoding-related steps provided in the foregoing method embodiments.

Finally, it should be noted that the foregoing descriptions are merely specific implementations of this application, but are not intended to limit the protection scope of this application. Any variation or replacement within the technical scope of the claims in this application shall fall within the protection scope of this application. Therefore, the protection scope of this application shall be subject to the protection scope of the claims.

## Claims

1. An encoding method, wherein the method comprises:
obtaining to-be-encoded 3-bit data;
encoding the 3-bit data, to obtain a 4-bit encoded parity signal, wherein the 3-bit data comprises first bit data A, second bit data B, and third bit data C, and the 4-bit encoded parity signal comprises a first encoded odd-bit signal S1, a second encoded odd-bit signal S2, a first encoded even-bit signal S3, and a second encoded even-bit signal S4 that satisfy *S*1=*A•*(*B+C*), *S*2 = *A̅ •* (*B + C̅*), *S*3=(*A̅+B̅*)*•C*, and *S*4=(*A+B̅*)•*C̅*, wherein • indicates logical AND, + indicates logical OR, *A̅* indicates an inverted phase of A, *B̅* indicates an inverted phase of B, and *C̅* indicates an inverted phase of C; and
generating a three-level pulse amplitude modulation, PAM3, signal in two unit intervals based on the 4-bit encoded parity signal, and sending the PAM3 signal.

2. The method according to claim 1, wherein the encoding the 3-bit data, to obtain a 4-bit encoded parity signal comprises:
if the 3-bit data is 111, encoding 111, to obtain a 4-bit encoded parity signal 1000;
if the 3-bit data is 110, encoding 110, to obtain a 4-bit encoded parity signal 1001;
if the 3-bit data is 001, encoding 001, to obtain a 4-bit encoded parity signal 0010;
if the 3-bit data is 101, encoding 101, to obtain a 4-bit encoded parity signal 1010;
if the 3-bit data is 100, encoding 100, to obtain a 4-bit encoded parity signal 0001;
if the 3-bit data is 011, encoding 011, to obtain a 4-bit encoded parity signal 0110;
if the 3-bit data is 010, encoding 010, to obtain a 4-bit encoded parity signal 0100; and
if the 3-bit data is 000, encoding 000, to obtain a 4-bit encoded parity signal 0101.

3. The method according to claim 1 or 2, wherein the encoded odd-bit signals at the first 2 bits of the 4-bit encoded parity signal are used to generate a PAM3 signal in a 1^{st} unit interval, and the encoded even-bit signals at the last 2 bits are used to generate a PAM3 signal in a 2^{nd} unit interval.

4. The method according to any one of claims 1 to 3, wherein the obtaining to-be-encoded 3-bit data comprises:
receiving a serial bitstream, and dividing the serial bitstream into a plurality of pieces of 3-bit data at a granularity of 3 bits, wherein the to-be-encoded 3-bit data is any one of the plurality of pieces of 3-bit data.

5. A decoding method, wherein the method comprises:
obtaining a three-level pulse amplitude modulation, PAM3, signal in two unit intervals;
determining a 4-bit decoding parity signal based on the PAM3 signal in the two unit intervals; and
decoding the 4-bit decoding parity signal, to obtain 3-bit data, wherein if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000.

6. The method according to claim 5, wherein the 4-bit decoding parity signal comprises a first decoding odd-bit signal C1, a second decoding odd-bit signal C2, a first decoding even-bit signal C3, and a second decoding even-bit signal C4, and the 3-bit data comprises first bit data A, second bit data B, and third bit data C that satisfy *A*=*C*1+(*̅C̅*̅3̅•*C*2), *B*=(*̅C̅*̅3̅*•C*4)*+*(*̅C̅*̅3̅*•C*1)*+*(*̅C̅*̅2̅*•C*4), and *C*=*C*3*+C*4*•C*2, wherein
• indicates logical AND, + indicates logical OR, *̅C̅*̅3̅ indicates an inverted phase of C3, and *̅C̅*̅2̅ indicates an inverted phase of C2.

7. The method according to claim 5 or 6, wherein the decoding odd-bit signals at the first 2 bits of the 4-bit decoding parity signal are determined based on a PAM3 signal in a 1^{st} unit interval, and the decoding even-bit signals at the last 2 bits are determined based on a PAM3 signal in a 2^{nd} unit interval.

8. The method according to any one of claims 5 to 7, wherein the method further comprises:
determining a serial bitstream based on the plurality pieces of 3-bit data.

9. An encoding apparatus, wherein the apparatus comprises:
an encoder, configured to obtain to-be-encoded 3-bit data, wherein
the encoder is further configured to encode the 3-bit data, to obtain a 4-bit encoded parity signal, wherein the 3-bit data comprises first bit data A, second bit data B, and third bit data C, and the 4-bit encoded parity signal comprises a first encoded odd-bit signal S1, a second encoded odd-bit signal S2, a first encoded even-bit signal S3, and a second encoded even-bit signal S4 that satisfy *S*1=*A•*(*B+C*), *S*2=*A̅•*(*B+C̅*), *S*3=(*A̅+B̅*)•*C*, and *S*4=(*A+B̅*)*•C*, wherein • indicates logical AND, + indicates logical OR, *A̅* indicates an inverted phase of A, *B̅* indicates an inverted phase of B, and *C̅* indicates an inverted phase of C; and
a driver, configured to generate a three-level pulse amplitude modulation, PAM3, signal in two unit intervals based on the 4-bit encoded parity signal, and send the PAM3 signal.

10. The apparatus according to claim 9, wherein the encoder is further configured to:
if the 3-bit data is 111, encode 111, to obtain a 4-bit encoded parity signal 1000; and
if the 3-bit data is 110, encode 110, to obtain a 4-bit encoded parity signal 1001; and
if the 3-bit data is 001, encode 001, to obtain a 4-bit encoded parity signal 0010; and
if the 3-bit data is 101, encode 101, to obtain a 4-bit encoded parity signal 1010; and
if the 3-bit data is 100, encode 100, to obtain a 4-bit encoded parity signal 0001; and
if the 3-bit data is 011, encode 011, to obtain a 4-bit encoded parity signal 0110; and
if the 3-bit data is 010, encode 010, to obtain a 4-bit encoded parity signal 0100; and
if the 3-bit data is 000, encode 000, to obtain a 4-bit encoded parity signal 0101.

11. The apparatus according to claim 9 or 10, wherein the encoded odd-bit signals at the first 2 bits of the 4-bit encoded parity signal are used to generate a PAM3 signal in a 1^{st} unit interval, and the encoded even-bit signals at the last 2 bits are used to generate a PAM3 signal in a 2^{nd} unit interval.

12. The apparatus according to any one of claims 9 to 11, wherein the apparatus further comprises:
a shift register, configured to receive a serial bitstream, and divide the serial bitstream into a plurality of pieces of 3-bit data at a granularity of 3 bits, wherein the to-be-encoded 3-bit data is any one of the plurality of pieces of 3-bit data.

13. A decoding apparatus, wherein the apparatus comprises:
a comparator, configured to obtain a three-level pulse amplitude modulation, PAM3, signal in two unit intervals, and determine a 4-bit decoding parity signal based on the PAM3 signal in the two unit intervals; and
a decoder, configured to decode the 4-bit decoding parity signal, to obtain 3-bit data, wherein if the 4-bit decoding parity signal is 1101 or 0101, the 3-bit data is 111; if the 4-bit decoding parity signal is 1100, the 3-bit data is 110; if the 4-bit decoding parity signal is 0111, the 3-bit data is 001; if the 4-bit decoding parity signal is 1111, the 3-bit data is 101; if the 4-bit decoding parity signal is 0100, the 3-bit data is 100; if the 4-bit decoding parity signal is 0011, the 3-bit data is 011; if the 4-bit decoding parity signal is 0001, the 3-bit data is 010; and if the 4-bit decoding parity signal is 0000, the 3-bit data is 000.

14. The apparatus according to claim 13, wherein the 4-bit decoding parity signal comprises a first decoding odd-bit signal C1, a second decoding odd-bit signal C2, a first decoding even-bit signal C3, and a second decoding even-bit signal C4, and the 3-bit data comprises first bit data A, second bit data B, and third bit data C that satisfy
*A*=*C*1*+*(*̅C̅*̅3̅*•C*2), *B*=(*̅C̅*̅3̅•*C*4)+(*̅C̅*̅3̅•*C*1)+(*̅C̅*̅2̅•*C*4), and *C*=*C*3+*C*4•*C*2, wherein
• indicates logical AND, + indicates logical OR, *̅C̅*̅3̅ indicates an inverted phase of C3, and *̅C̅*̅2̅ indicates an inverted phase of C2.

15. The apparatus according to claim 13 or 14, wherein the decoding odd-bit signals at the first 2 bits of the 4-bit decoding parity signal are determined based on a PAM3 signal in a 1^{st} unit interval, and the decoding even-bit signals at the last 2 bits are determined based on a PAM3 signal in a 2^{nd} unit interval.

## Patentansprüche

1. Codierungsverfahren, wobei das Verfahren Folgendes umfasst:
Erlangen zu codierender 3-Bit-Daten;
Codieren der 3-Bit-Daten, um ein codiertes 4-Bit-Paritätssignal zu erlangen, wobei die 3-Bit-Daten erste Bit-Daten A, zweite Bit-Daten B und dritte Bit-Daten C umfassen und das codierte 4-Bit-Paritätssignal ein erstes codiertes ungerades Bit-Signal S1, ein zweites codiertes ungerades Bit-Signal S2, ein erstes codiertes gerades Bit-Signal S3 und ein zweites codiertes gerades Bit-Signal S4 umfasst, welche die Bedingung *S*1 = *A* • (*B + C*), *S*2 = *A̅•*(*B+C̅*), *S*3=(*A̅+B̅*)•*C* und *S*4=(*A+B̅*)•*C̅* erfüllen, wobei • ein logisches UND anzeigt, + ein logisches ODER anzeigt, *A̅* eine invertierte Phase von A anzeigt, *B̅* eine invertierte Phase von B anzeigt und *C̅* eine invertierte Phase von C anzeigt; und
Erzeugen eines dreistufigen Pulsamplitudenmodulationssignals, PAM3-Signals, in Intervallen von zwei Einheiten basierend auf dem codierten 4-Bit-Paritätssignal und Senden des PAM3-Signals.

2. Verfahren nach Anspruch 1, wobei das Codieren der 3-Bit-Daten, um ein codiertes 4-Bit-Paritätssignal zu erlangen, Folgendes umfasst:
wenn die 3-Bit-Daten 111 sind, Codieren von 111, um ein codiertes 4-Bit-Paritätssignal 1000 zu erlangen;
wenn die 3-Bit-Daten 110 sind, Codieren von 110, um ein codiertes 4-Bit-Paritätssignal 1001 zu erlangen;
wenn die 3-Bit-Daten 001 sind, Codieren von 001, um ein codiertes 4-Bit-Paritätssignal 0010 zu erlangen;
wenn die 3-Bit-Daten 101 sind, Codieren von 101, um ein codiertes 4-Bit-Paritätssignal 1010 zu erlangen;
wenn die 3-Bit-Daten 100 sind, Codieren von 100, um ein codiertes 4-Bit-Paritätssignal 0001 zu erlangen;
wenn die 3-Bit-Daten 011 sind, Codieren von 011, um ein codiertes 4-Bit-Paritätssignal 0110 zu erlangen;
wenn die 3-Bit-Daten 010 sind, Codieren von 010, um ein codiertes 4-Bit-Paritätssignal 0100 zu erlangen; und
wenn die 3-Bit-Daten 000 sind, Codieren von 000, um ein codiertes 4-Bit-Paritätssignal 0101 zu erlangen.

3. Verfahren nach Anspruch 1 oder 2, wobei die codierten ungeraden Bit-Signale an den ersten 2 Bits des codierten 4-Bit-Paritätssignals dazu verwendet werden, ein PAM3-Signal in einem ersten Einheitsintervall zu erzeugen, und die codierten geraden Bit-Signale an den letzten 2 Bits dazu verwendet werden, ein PAM3-Signal in einem zweiten Einheitsintervall zu erzeugen.

4. Verfahren nach einem der Ansprüche 1 bis 3, wobei das Erlangen der zu codierenden 3-Bit-Daten Folgendes umfasst:
Empfangen eines seriellen Bit-Stroms und Teilen des seriellen Bit-Stroms in eine Vielzahl von 3-Bit-Datenteilen mit einer Granularität von 3 Bit, wobei die zu codierenden 3-Bit-Daten ein beliebiges der Vielzahl von 3-Bit-Datenteilen sind.

5. Decodierungsverfahren, wobei das Verfahren Folgendes umfasst:
Erlangen eines dreistufigen Pulsamplitudenmodulationssignals, PAM3-Signals, in Intervallen von zwei Einheiten;
Bestimmen eines 4-Bit-Decodierungsparitätssignals basierend auf dem PAM3-Signal in den Intervallen von zwei Einheiten; und
Decodieren des 4-Bit-Decodierungsparitätssignals, um 3-Bit-Daten zu erlangen, wobei, wenn das 4-Bit-Decodierungsparitätssignal 1101 oder 0101 ist, die 3-Bit-Daten 111 sind; wenn das 4-Bit-Decodierungsparitätssignal 1100 ist, die 3-Bit-Daten 110 sind; wenn das 4-Bit-Decodierungsparitätssignal 0111 ist, die 3-Bit-Daten 001 sind;
wenn das 4-Bit-Decodierungsparitätssignal 1111 ist, die 3-Bit-Daten 101 sind; wenn das 4-Bit-Decodierungsparitätssignal 0100 ist, die 3-Bit-Daten 100 sind; wenn das 4-Bit-Decodierungsparitätssignal 0011 ist, die 3-Bit-Daten 011 sind;
wenn das 4-Bit-Decodierungsparitätssignal 0001 ist, die 3-Bit-Daten 010 sind; und wenn das 4-Bit-Decodierungsparitätssignal 0000 ist, die 3-Bit-Daten 000 sind.

6. Verfahren nach Anspruch 5, wobei das 4-Bit-Decodierungsparitätssignal ein erstes Decodierungssignal für ungerade Bits C1, ein zweites Decodierungssignal für ungerade Bits C2, ein erstes Decodierungssignal für gerade Bits C3 und ein zweites Decodierungssignal für gerade Bits C4 umfasst und die 3-Bit-Daten erste Bit-Daten A, zweite Bit-Daten B und dritte Bit-Daten C umfassen, die *A* = *C*1 + (*C̅3̅•C*2), *B* = (*C̅3̅•C*4) *+* (*C̅3̅•C*1) *+* (*C̅2̅*•*C*4) und *C* = C3 + *C*4•*C*2 erfüllen, wobei
• ein logisches UND anzeigt, + ein logisches ODER anzeigt, *C̅3̅* eine invertierte Phase von C3 anzeigt und *C̅2̅* eine invertierte Phase von C2 anzeigt.

7. Verfahren nach Anspruch 5 oder 6, wobei die Decodierungssignale für ungerade Bits an den ersten 2 Bits des 4-Bit-Decodierungsparitätssignals basierend auf einem PAM3-Signal in einem ersten Einheitsintervall bestimmt werden und die Decodierungssignale für gerade Bits an den letzten 2 Bits basierend auf einem PAM3-Signal in einem zweiten Einheitsintervall bestimmt werden.

8. Verfahren nach einem der Ansprüche 5 bis 7, wobei das Verfahren ferner Folgendes umfasst:
Bestimmen eines seriellen Bit-Stroms basierend auf der Vielzahl 3-Bit-Datenteile.

9. Codierungsvorrichtung, wobei die Vorrichtung Folgendes umfasst:
einen Encoder, der dazu konfiguriert ist, zu codierende 3-Bit-Daten zu erlangen, wobei
der Encoder ferner dazu konfiguriert ist, die 3-Bit-Daten zu codieren, um ein codiertes 4-Bit-Paritätssignal zu erlangen, wobei die 3-Bit-Daten erste Bit-Daten A, zweite Bit-Daten B und dritte Bit-Daten C umfassen und das codierte 4-Bit-Paritätssignal ein erstes codiertes ungerades Bit-Signal S1, ein zweites codiertes ungerades Bit-Signal S2, ein erstes codiertes gerades Bit-Signal S3 und ein zweites codiertes gerades Bit-Signal S4 umfasst, welche die Bedingung *S*1 = *A* • (*B + C*), *S*2 = *A̅ •* (*B* + *C̅*)*, S*3=(*A̅+B̅*)•*C* und *S*4=(*A+B̅*)•*C* erfüllen, wobei • ein logisches UND anzeigt, + ein logisches ODER anzeigt, *A̅* eine invertierte Phase von A anzeigt, *B̅* eine invertierte Phase von B anzeigt und *C̅* eine invertierte Phase von C anzeigt; und
einen Treiber, der dazu konfiguriert ist, ein dreistufiges Pulsamplitudenmodulationssignal, PAM3-Signal, in Intervallen von zwei Einheiten basierend auf dem codierten 4-Bit-Paritätssignal zu erzeugen und das PAM3-Signal zu senden.

10. Vorrichtung nach Anspruch 9, wobei der Encoder ferner zu Folgendem konfiguriert ist:
wenn die 3-Bit-Daten 111 sind, Codieren von 111, um ein codiertes 4-Bit-Paritätssignal 1000 zu erlangen; und
wenn die 3-Bit-Daten 110 sind, Codieren von 110, um ein codiertes 4-Bit-Paritätssignal 1001 zu erlangen; und
wenn die 3-Bit-Daten 001 sind, Codieren von 001, um ein codiertes 4-Bit-Paritätssignal 0010 zu erlangen; und
wenn die 3-Bit-Daten 101 sind, Codieren von 101, um ein codiertes 4-Bit-Paritätssignal 1010 zu erlangen; und
wenn die 3-Bit-Daten 100 sind, Codieren von 100, um ein codiertes 4-Bit-Paritätssignal 0001 zu erlangen; und
wenn die 3-Bit-Daten 011 sind, Codieren von 011, um ein codiertes 4-Bit-Paritätssignal 0110 zu erlangen; und
wenn die 3-Bit-Daten 010 sind, Codieren von 010, um ein codiertes 4-Bit-Paritätssignal 0100 zu erlangen; und
wenn die 3-Bit-Daten 000 sind, Codieren von 000, um ein codiertes 4-Bit-Paritätssignal 0101 zu erlangen.

11. Vorrichtung nach Anspruch 9 oder 10, wobei die codierten ungeraden Bit-Signale an den ersten 2 Bits des codierten 4-Bit-Paritätssignals dazu verwendet werden, ein PAM3-Signal in einem ersten Einheitsintervall zu erzeugen, und die codierten geraden Bit-Signale an den letzten 2 Bits dazu verwendet werden, ein PAM3-Signal in einem zweiten Einheitsintervall zu erzeugen.

12. Vorrichtung nach einem der Ansprüche 9 bis 11, wobei die Vorrichtung ferner Folgendes umfasst:
ein Schieberegister, das dazu konfiguriert ist, einen seriellen Bit-Strom zu empfangen und den seriellen Bit-Strom in eine Vielzahl von 3-Bit-Datenteilen mit einer Granularität von 3 Bit zu teilen, wobei die zu codierenden 3-Bit-Daten ein beliebiges der Vielzahl von 3-Bit-Datenteilen sind.

13. Decodierungsvorrichtung, wobei die Vorrichtung Folgendes umfasst:
einen Komparator, der dazu konfiguriert ist, ein dreistufiges Pulsamplitudenmodulationssignal, PAM3-Signal, in Intervallen von zwei Einheiten zu erlangen und ein 4-Bit-Decodierungsparitätssignal basierend auf dem PAM3-Signal in Intervallen von zwei Einheiten zu bestimmen; und
einen Decodierer, der dazu konfiguriert ist, das 4-Bit-Decodierungsparitätssignal zu decodieren, um 3-Bit-Daten zu erlangen, wobei, wenn das 4-Bit-Decodierungsparitätssignal 1101 oder 0101 ist, die 3-Bit-Daten 111 sind; wenn das 4-Bit-Decodierungsparitätssignal 1100 ist, die 3-Bit-Daten 110 sind;
wenn das 4-Bit-Decodierungsparitätssignal 0111 ist, die 3-Bit-Daten 001 sind; wenn das 4-Bit-Decodierungsparitätssignal 1111 ist, die 3-Bit-Daten 101 sind; wenn das 4-Bit-Decodierungsparitätssignal 0100 ist, die 3-Bit-Daten 100 sind;
wenn das 4-Bit-Decodierungsparitätssignal 0011 ist, die 3-Bit-Daten 011 sind; wenn das 4-Bit-Decodierungsparitätssignal 0001 ist, die 3-Bit-Daten 010 sind; und wenn das 4-Bit-Decodierungsparitätssignal 0000 ist, die 3-Bit-Daten 000 sind.

14. Vorrichtung nach Anspruch 13, wobei das 4-Bit-Decodierungsparitätssignal ein erstes Decodierungssignal für ungerade Bits C1, ein zweites Decodierungssignal für ungerade Bits C2, ein erstes Decodierungssignal für gerade Bits C3 und ein zweites Decodierungssignal für gerade Bits C4 umfasst und die 3-Bit-Daten erste Bit-Daten A, zweite Bit-Daten B und dritte Bit-Daten C umfassen, die
*A* = *C*1 *+* (*C̅3̅•C*2), *B* = (*C̅3̅•C*4) *+* (*C̅3̅•C*1) *+* (*C̅2̅•C*4) und *C* = *C*3 + *C*4•*C*2 erfüllen, wobei
• ein logisches UND anzeigt, + ein logisches ODER anzeigt, *̅C̅*̅3̅ eine invertierte Phase von C3 anzeigt und *̅C̅*̅2̅ eine invertierte Phase von C2 anzeigt.

15. Vorrichtung nach Anspruch 13 oder 14, wobei die Decodierungssignale für ungerade Bits an den ersten 2 Bits des 4-Bit-Decodierungsparitätssignals basierend auf einem PAM3-Signal in einem ersten Einheitsintervall bestimmt werden und die Decodierungssignale für gerade Bits an den letzten 2 Bits basierend auf einem PAM3-Signal in einem zweiten Einheitsintervall bestimmt werden.

## Revendications

1. Procédé de codage, dans lequel le procédé comprend :
l'obtention de données à coder sur 3 bits ;
le codage des données sur 3 bits, pour obtenir un signal de parité codé sur 4 bits, dans lequel les données sur 3 bits comprennent des données de premier bit A, des données de deuxième bit B et des données de troisième bit C, et le signal de parité codé sur 4 bits comprend un premier signal de bit impair codé S1, un second signal de bit impair codé S2, un premier signal de bit pair codé S3 et un second signal de bit pair codé S4 qui satisfont à *S*1 = A • (*B + C*), *S*2 = *A̅•*(*B+C̅*), *S*3=(*A̅+B̅*)•*C,* et *S*4 = (*A+B̅*)*•C̅,* dans lequel • indique un ET logique, + indique un OU logique, *A̅* indique une phase inversée de A, *B̅* indique une phase inversée de B et *C̅* indique une phase inversée de C ; et
la génération d'un signal de modulation d'amplitude d'impulsion à trois niveaux, PAM3, dans deux intervalles unitaires sur la base du signal de parité codé sur 4 bits, et l'envoi du signal PAM3.

2. Procédé selon la revendication 1, dans lequel le codage des données sur 3 bits, pour obtenir un signal de parité codé sur 4 bits, comprend :
si les données sur 3 bits sont 111, le codage de 111, pour obtenir un signal de parité codé sur 4 bits 1000 ;
si les données sur 3 bits sont 110, le codage de 110, pour obtenir un signal de parité codé sur 4 bits 1001 ;
si les données sur 3 bits sont 001, le codage de 001, pour obtenir un signal de parité codé sur 4 bits 0010 ;
si les données sur 3 bits sont 101, le codage de 101, pour obtenir un signal de parité codé sur 4 bits 1010 ;
si les données sur 3 bits sont 100, le codage de 100, pour obtenir un signal de parité codé sur 4 bits 0001 ;
si les données sur 3 bits sont 011, le codage de 011, pour obtenir un signal de parité codé sur 4 bits 0110 ;
si les données sur 3 bits sont 010, le codage de 010, pour obtenir un signal de parité codé sur 4 bits 0100 ; et
si les données sur 3 bits sont 000, le codage de 000, pour obtenir un signal de parité codé sur 4 bits 0101.

3. Procédé selon la revendication 1 ou 2, dans lequel les signaux de bits impairs codés aux 2 premiers bits du signal de parité codé sur 4 bits sont utilisés pour générer un signal PAM3 dans un 1^{er} intervalle unitaire, et les signaux de bits pairs codés aux 2 derniers bits sont utilisés pour générer un signal PAM3 dans un 2^{ème} intervalle unitaire.

4. Procédé selon l'une quelconque des revendications 1 à 3, dans lequel l'obtention de données sur 3 bits à coder comprend :
la réception d'un flux binaire en série et la division du flux binaire en série en une pluralité d'éléments de données sur 3 bits à une granularité de 3 bits, dans lequel les données sur 3 bits à coder sont l'un quelconque de la pluralité d'éléments de données sur 3 bits.

5. Procédé de décodage, dans lequel le procédé comprend :
l'obtention d'un signal de modulation d'amplitude d'impulsion à trois niveaux, PAM3, dans deux intervalles unitaires ;
la détermination d'un signal de parité de décodage sur 4 bits sur la base du signal PAM3 dans les deux intervalles unitaires ; et
le décodage du signal de parité de décodage sur 4 bits, pour obtenir des données sur 3 bits, dans lequel si le signal de parité de décodage sur 4 bits est 1101 ou 0101, les données sur 3 bits sont 111 ; si le signal de parité de décodage sur 4 bits est 1100, les données sur 3 bits sont 110 ; si le signal de parité de décodage sur 4 bits est 0111, les données sur 3 bits sont 001 ; si le signal de parité de décodage sur 4 bits est 1111, les données sur 3 bits sont 101 ; si le signal de parité de décodage sur 4 bits est 0100, les données sur 3 bits sont 100 ; si le signal de parité de décodage sur 4 bits est 0011, les données sur 3 bits sont 011 ; si le signal de parité de décodage sur 4 bits est 0001, les données sur 3 bits sont 010 ; et si le signal de parité de décodage sur 4 bits est 0000, les données sur 3 bits sont 000.

6. Procédé selon la revendication 5, dans lequel le signal de parité de décodage sur 4 bits comprend un premier signal de bit impair de décodage C1, un second signal de bit impair de décodage C2, un premier signal de bit pair de décodage C3 et un second signal de bit pair de décodage C4, et les données sur 3 bits comprennent des données de premier bit A, des données de deuxième bit B et des données de troisième bit C qui satisfont à *A* = *C*1 + (*C̅3̅•C*2), *B* = (*C̅3̅•C*4) *+* (*C̅3̅•C*1) *+* (*C̅2̅•C*4), et *C* = *C*3 *+ C*4*•C*2, dans lequel
• indique un ET logique, + indique un OU logique, *C̅3̅* indique une phase inversée de C3 et *C̅2̅* indique une phase inversée de C2.

7. Procédé selon la revendication 5 ou 6, dans lequel les signaux de bits impairs de décodage aux 2 premiers bits du signal de parité de décodage sur 4 bits sont déterminés sur la base d'un signal PAM3 dans un 1^{er} intervalle unitaire, et les signaux de bits pairs de décodage aux 2 derniers bits sont déterminés sur la base d'un signal PAM3 dans un 2^{ème} intervalle unitaire.

8. Procédé selon l'une quelconque des revendications 5 à 7, dans lequel le procédé comprend en outre :
la détermination d'un flux binaire en série sur la base de la pluralité d'éléments de données sur 3 bits.

9. Appareil de codage, dans lequel l'appareil comprend :
un codeur, configuré pour obtenir des données sur 3 bits à coder, dans lequel
le codeur est en outre configuré pour coder les données sur 3 bits, pour obtenir un signal de parité codé sur 4 bits, dans lequel les données sur 3 bits comprennent des données de premier bit A, des données de deuxième bit B et des données de troisième bit C, et le signal de parité codé sur 4 bits comprend un premier signal de bit impair codé S1, un second signal de bit impair codé S2, un premier signal de bit pair codé S3 et un second signal de bit pair codé S4 qui satisfont à *S*1 = A • (*B + C*), *S*2 = *A̅ •* (*B + C̅*), *S*3=(*A̅+B̅*)*•C,* et *S*4=(*A+B̅*)*• C̅*, dans lequel • indique un ET logique, + indique un OU logique, *A̅* indique une phase inversée de A, *B̅* indique une phase inversée de B et *C̅* indique une phase inversée de C ; et
un pilote, configuré pour générer un signal de modulation d'amplitude d'impulsion à trois niveaux, PAM3, dans deux intervalles unitaires sur la base du signal de parité codé sur 4 bits, et envoyer le signal PAM3.

10. Appareil selon la revendication 9, dans lequel le codeur est en outre configuré pour :
si les données sur 3 bits sont 111, coder 111, pour obtenir un signal de parité codé sur 4 bits 1000 ; et
si les données sur 3 bits sont 110, coder 110, pour obtenir un signal de parité codé sur 4 bits 1001 ; et
si les données sur 3 bits sont 001, coder 001, pour obtenir un signal de parité codé sur 4 bits 0010 ; et
si les données sur 3 bits sont 101, coder 101, pour obtenir un signal de parité codé sur 4 bits 1010 ; et
si les données sur 3 bits sont 100, coder 100, pour obtenir un signal de parité codé sur 4 bits 0001 ; et
si les données sur 3 bits sont 011, coder 011, pour obtenir un signal de parité codé sur 4 bits 0110 ; et
si les données sur 3 bits sont 010, coder 010, pour obtenir un signal de parité codé sur 4 bits 0100 ; et
si les données sur 3 bits sont 000, coder 000, pour obtenir un signal de parité codé sur 4 bits 0101.

11. Appareil selon la revendication 9 ou 10, dans lequel les signaux de bits impairs codés aux 2 premiers bits du signal de parité codé sur 4 bits sont utilisés pour générer un signal PAM3 dans un 1^{er} intervalle unitaire, et les signaux de bits pairs codés aux 2 derniers bits sont utilisés pour générer un signal PAM3 dans un 2^{ème} intervalle unitaire.

12. Appareil selon l'une quelconque des revendications 9 à 11, dans lequel l'appareil comprend en outre :
un registre à décalage configuré pour recevoir un flux binaire en série et diviser le flux binaire en série en une pluralité d'éléments de données sur 3 bits à une granularité de 3 bits, dans lequel les données sur 3 bits à coder sont l'un quelconque de la pluralité d'éléments de données sur 3 bits.

13. Appareil de décodage, dans lequel l'appareil comprend :
un comparateur, configuré pour obtenir un signal de modulation d'amplitude d'impulsion à trois niveaux, PAM3, dans deux intervalles unitaires, et pour déterminer un signal de parité de décodage sur 4 bits sur la base du signal PAM3 dans les deux intervalles unitaires ; et
un décodeur, configuré pour décoder le signal de parité de décodage sur 4 bits, pour obtenir des données sur 3 bits, dans lequel si le signal de parité de décodage sur 4 bits est 1101 ou 0101, les données sur 3 bits sont 111 ; si le signal de parité de décodage sur 4 bits est 1100, les données sur 3 bits sont 110 ; si le signal de parité de décodage sur 4 bits est 0111, les données sur 3 bits sont 001 ; si le signal de parité de décodage sur 4 bits est 1111, les données sur 3 bits sont 101 ; si le signal de parité de décodage sur 4 bits est 0100, les données sur 3 bits sont 100 ; si le signal de parité de décodage sur 4 bits est 0011, les données sur 3 bits sont 011 ; si le signal de parité de décodage sur 4 bits est 0001, les données sur 3 bits sont 010 ; et si le signal de parité de décodage sur 4 bits est 0000, les données sur 3 bits sont 000.

14. Appareil selon la revendication 13, dans lequel le signal de parité de décodage sur 4 bits comprend un premier signal de bit impair de décodage C1, un second signal de bit impair de décodage C2, un premier signal de bit pair de décodage C3 et un second signal de bit pair de décodage C4, et les données sur 3 bits comprennent des données de premier bit A, des données de deuxième bit B et des données de troisième bit C qui satisfont à
*A* = *C*1 *+* (*C̅3̅•C*2), *B* = (*C̅3̅•C*4) *+* (*C̅3̅•C*1) *+* (*C̅2̅•C*4), et *C* = *C*3 + *C*4*•C*2, dans lequel
• indique un ET logique, + indique un OU logique, *C̅3̅* indique une phase inversée de C3 et *C̅2̅* indique une phase inversée de C2.

15. Appareil selon la revendication 13 ou 14, dans lequel les signaux de bits impairs de décodage aux 2 premiers bits du signal de parité de décodage sur 4 bits sont déterminés sur la base d'un signal PAM3 dans un 1^{er} intervalle unitaire, et les signaux de bits pairs de décodage aux 2 derniers bits sont déterminés sur la base d'un signal PAM3 dans un 2^{ème} intervalle unitaire.
